# EUROPEAN PATENT APPLICATION

(11) **EP 4 791 175 A1**
(43) Date of publication of application: **12.08.2026**
(21) Application number: 26155998.3
(22) Date of filing: 03.02.2026
(51) Int. Cl.: H10W 20/40, H10W 20/41, H10W 20/00, H10D 30/00, H10D 62/10, H10D 64/23, H10D 84/83, H10W 20/42

(54) **SEMICONDUCTOR DEVICE**

(30) Priority: 11.02.2025 KR 20250017394
(71) Applicant: Samsung Electronics Co., Ltd., Suwon-si, Gyeonggi-do 16677 (KR)
(72) Inventor: LEE, Yong Woo, 16677 Suwon-si (KR); KIM, Jee Woong, 16677 Suwon-si (KR); KIM, Jin Kyu, 16677 Suwon-si (KR); NAM, Yun Suk, 16677 Suwon-si (KR); SHIN, Jae Hoon, 16677 Suwon-si (KR); CHO, Keun Hwi, 16677 Suwon-si (KR); FUKUTOME, Hidenobu, 16677 Suwon-si (KR)
(74) Representative: Marks & Clerk LLP

(57) **Abstract**

A semiconductor device includes a substrate including a first surface and a second surface opposite to the first surface, a first active pattern on the first surface of the substrate and extending in a first direction, a first gate structure on the first active pattern and extending in a second direction intersecting the first direction, a first epitaxial pattern on at least one side of the first gate structure and connected to the first active pattern, a first frontside source/drain contact on a first surface of the first epitaxial pattern and connected to the first epitaxial pattern, a frontside wiring structure on a first surface of the first frontside source/drain contact and connected to the first frontside source/drain contact, and an insulating pattern on a second surface of the first gate structure and extending in the second direction.

## Description

### BACKGROUND

### 1. Field

The present disclosure relates to a semiconductor device, and in particular, to a semiconductor device including Backside Power Delivery Network (BSPDN).

### 2. Description of Related Art

Due to characteristics such as miniaturization, multifunctionalization, and/or low manufacturing cost, a semiconductor device is attracting attention as an important factor in the electronics industry. The semiconductor devices may be classified into a semiconductor memory device for storing logic data therein, a semiconductor logic device for processing logic data, and a hybrid semiconductor device including a memory element and a logic element.

As the electronics industry is highly developed, there is an increasing demand for characteristics of the semiconductor device. For example, there is a growing demand for high reliability, high speed, and/or multi-functionalization of the semiconductor device. In order to meet these required characteristics, structures in the semiconductor device are becoming increasingly complex and highly integrated.

As the semiconductor device becomes more highly integrated, widths of wiring patterns and via patterns implementing the semiconductor device are gradually decreasing. Accordingly, a voltage drop (e.g., IR drop) of a Power Delivery Network (PDN) that supplies a power voltage to an integrated circuit has become an important issue.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

One or more example embodiments provide a semiconductor device with improved design freedom and Power, Performance, Area, and Cost (PPAC).

Additional aspects will be set forth in part in the description which follows and, in part, will be apparent from the description, or may be learned by practice of the presented embodiments.

According to an aspect of an example embodiment, a semiconductor device may include a substrate including a first surface and a second surface opposite to the first surface, a first active pattern on the first surface of the substrate and extending in a first direction, a first gate structure on the first active pattern and extending in a second direction intersecting the first direction, a first epitaxial pattern on at least one side of the first gate structure and connected to the first active pattern, a first frontside source/drain contact on a first surface of the first epitaxial pattern and connected to the first epitaxial pattern, a frontside wiring structure on a first surface of the first frontside source/drain contact and connected to the first frontside source/drain contact, an insulating pattern on a second surface of the first gate structure and extending in the second direction, the insulating pattern contacting the first surface and the second surface of the substrate, a first backside contact via on at least one side of the insulating pattern, a first backside source/drain contact on a second surface of the first epitaxial pattern and connecting the first backside contact via to the first epitaxial pattern, and a backside wiring structure on the second surface of the substrate and connected to the first backside contact via.

According to an aspect of an example embodiment, a semiconductor device may include a substrate including a first surface and a second surface opposite to the first surface, a first active pattern on the first surface of the substrate and extending in a first direction, a second active pattern on the first surface of the substrate and spaced apart from the first active pattern in a second direction intersecting the first direction, where the second active pattern extends in the first direction, a first gate structure on the first active pattern and extending in the second direction, a second gate structure on the second active pattern and extending in the second direction, a first epitaxial pattern on at least one side of the first gate structure and connected to the first active pattern, a second epitaxial pattern on at least one side of the second gate structure and connected to the second active pattern, a frontside source/drain contact on aa first surface of the second epitaxial pattern and connected to the second epitaxial pattern, a frontside wiring structure on a first surface of the frontside source/drain contact and connected to the frontside source/drain contact, a backside contact via in the substrate and extending in the second direction, a first backside source/drain contact on a second surface of the first epitaxial pattern and connecting the backside contact via to the first epitaxial pattern, a second backside source/drain contact on a second surface of the second epitaxial pattern and connecting the backside contact via to the second epitaxial pattern, a first backside wiring pattern on the second surface of the substrate and connected to the backside contact via, and a second backside wiring pattern on the second surface of the substrate and spaced apart from the first backside wiring pattern in the second direction, where the second backside wiring pattern is connected to the backside contact via.

According to an aspect of an example embodiment, a semiconductor device may include a substrate including a first surface and a second surface opposite to the first surface, a first active pattern on the first surface of the substrate and extending in a first direction, a first gate structure on the first active pattern and extending in a second direction intersecting the first direction, a first epitaxial pattern on each of opposing sides of the first gate structure and connected to the first active pattern, a first frontside source/drain contact on a first surface of the first epitaxial pattern and connected to the first epitaxial pattern, a frontside wiring structure on a first surface of the first frontside source/drain contact and connected to the first frontside source/drain contact, an insulating pattern on a second surface of the first gate structure and extending in the second direction, the insulating pattern contacting the first surface and the second surface of the substrate, a first backside contact via on a first side of the insulating pattern, a second backside contact via on a second side of the insulating pattern, a first backside source/drain contact connecting the first backside contact via to the first epitaxial pattern, a second backside source/drain contact connecting the second backside contact via to the first epitaxial pattern, a first backside wiring pattern on the second surface of the substrate and connected to the first backside contact via, and a second backside wiring pattern on the second surface of the substrate and spaced apart from the first backside wiring pattern in the first direction, where the second backside wiring pattern is connected to the second backside contact via.

At least some of the above and other features of the invention are set out in the claims.

### BRIEF DESCRIPTION OF DRAWINGS

The above and other aspects, features, and advantages of certain example embodiments of the present disclosure will be more apparent from the following description taken in conjunction with the accompanying drawings, in which:
FIG. 1 is a diagram illustrating a semiconductor device according to one or more embodiments;
FIG. 2 is a cross-sectional view taken along a line A1-A1 of FIG. 1 according to one or more embodiments;
FIG. 3 is a cross-sectional view taken along a line B1-B1 of FIG. 1 according to one or more embodiments;
FIG. 4 is a cross-sectional view taken along a line C1-C1 of FIG. 1 according to one or more embodiments;
FIG. 5 is a cross-sectional view taken along a line D1-D1 of FIG. 1 according to one or more embodiments;
FIG. 6 is a cross-sectional view taken along a line E1-E1 of FIG. 1 according to one or more embodiments;
FIG. 7 is a diagram illustrating an electrical path of the semiconductor device of FIG. 1 according to one or more embodiments;
FIG. 8 is a diagram illustrating a semiconductor device according to one or more embodiments;
FIG. 9 is a cross-sectional view taken along a line F-F of FIG. 8 according to one or more embodiments;
FIG. 10 is a diagram illustrating a semiconductor device according to one or more embodiments;
FIG. 11 is a cross-sectional view taken along a line G-G of FIG. 10 according to one or more embodiments;
FIG. 12 is a diagram illustrating a semiconductor device according to one or more embodiments;
FIG. 13 is a cross-sectional view taken along a line H-H of FIG. 12 according to one or more embodiments;
FIG. 14 is a diagram illustrating a semiconductor device according to one or more embodiments;
FIG. 15 is a cross-sectional view taken along a line A2-A2 of FIG. 14 according to one or more embodiments;
FIG. 16 is a cross-sectional view taken along a line B2-B2 of FIG. 14 according to one or more embodiments;
FIG. 17 is a cross-sectional view taken along a line C2-C2 of FIG. 14 according to one or more embodiments;
FIG. 18 is a cross-sectional view taken along a line D2-D2 of FIG. 14 according to one or more embodiments;
FIG. 19 is a cross-sectional view taken along a line E2-E2 of FIG. 14 according to one or more embodiments; and
FIG. 20 is a diagram illustrating an electrical path of the semiconductor device of FIG. 14 according to one or more embodiments.

### DETAILED DESCRIPTION

Hereinafter, example embodiments of the disclosure will be described in detail with reference to the accompanying drawings. The same reference numerals are used for the same components in the drawings, and redundant descriptions thereof may be omitted. The embodiments described herein are example embodiments, and thus, the disclosure is not limited thereto and may be realized in various other forms.

In the detailed description, the term "same" may indicate not only completely same but also includes a minor difference due to process margin.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

Spatially relative terms should be interpreted to include different orientations of the device during use or operation, in addition to the orientation shown in the drawings. For example, if a device shown in the drawings is flipped, an element described as being "below" or "beneath" another element could be positioned "above" that other element. Thus, the term "below" may encompass both downward and upward directions. Components may be oriented in different directions, and accordingly, spatially relative terms should be interpreted based on such orientations.

Terms such as first, second, etc. may be used to describe various components, but are used only for the purpose of distinguishing one component from another component. These terms do not limit the difference in the material or structure of the components.

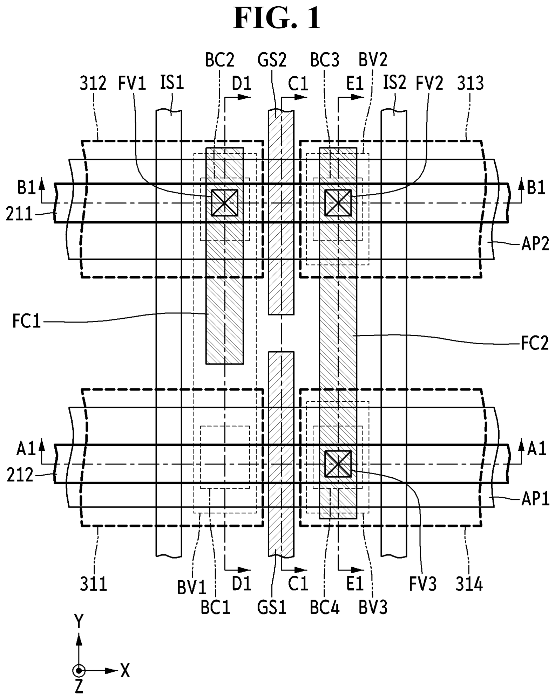

Hereinafter, a semiconductor device according to one or more embodiments will be described with reference to FIGS. 1 to 20.

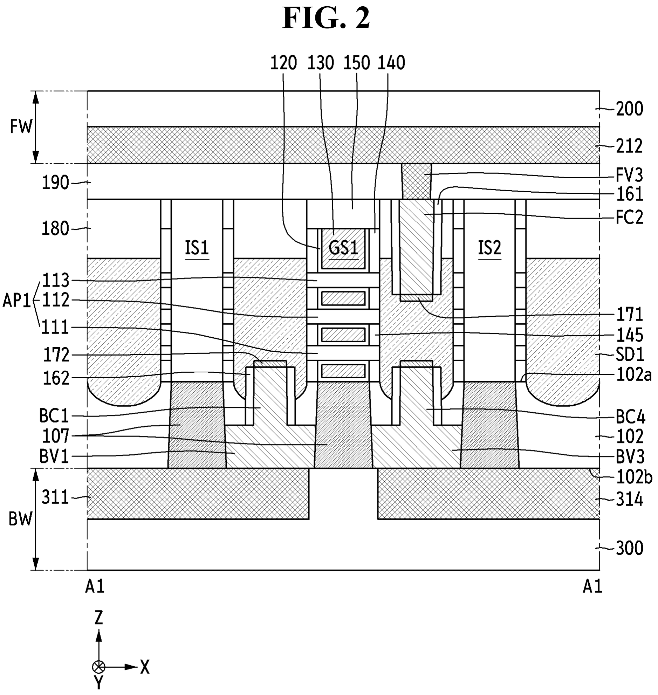

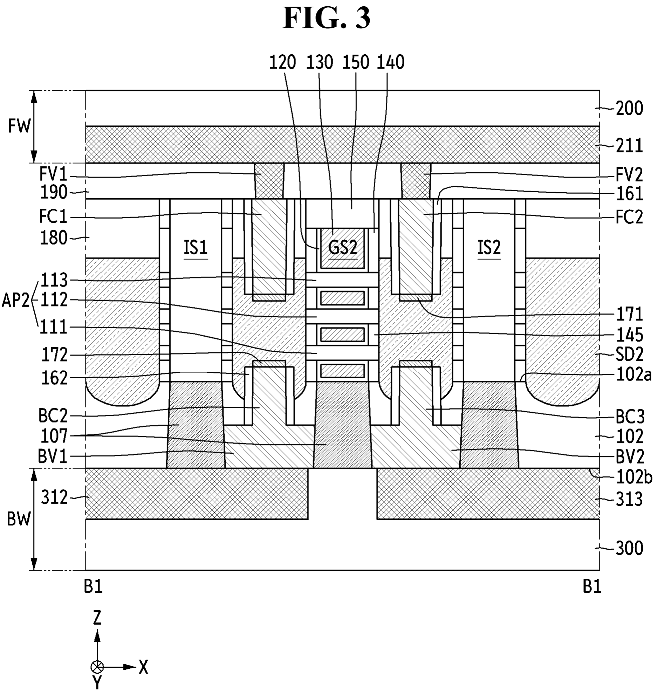

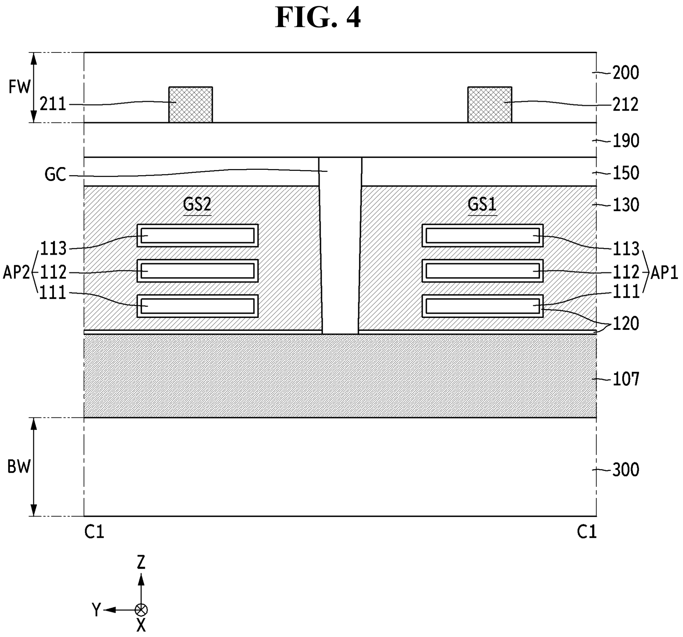

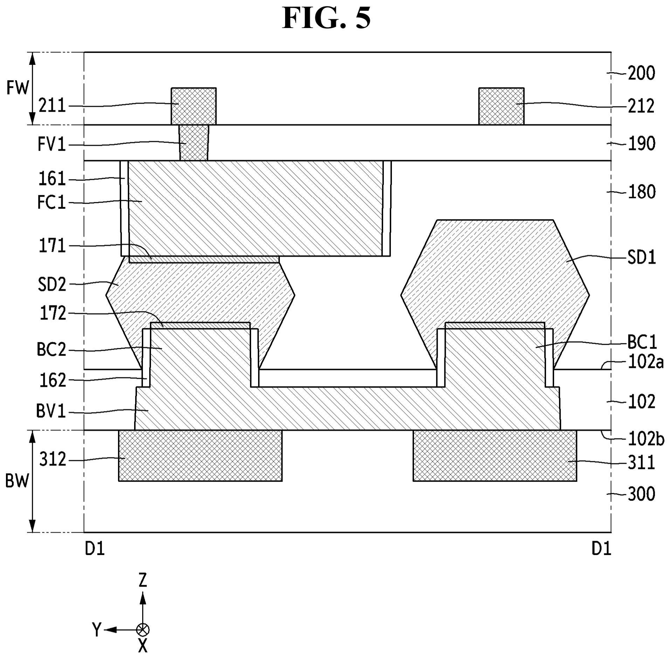

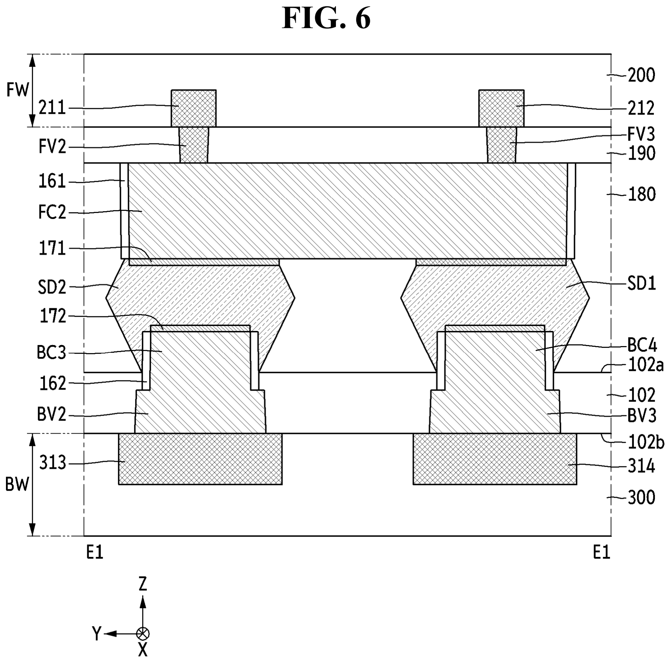

FIG. 1 is a diagram illustrating a semiconductor device according to one or more embodiments. FIG. 2 is a cross-sectional view taken along a line A1-A1 of FIG. 1 according to one or more embodiments. FIG. 3 is a cross-sectional view taken along a line B1-B1 of FIG. 1 according to one or more embodiments. FIG. 4 is a cross-sectional view taken along a line C1-C1 of FIG. 1 according to one or more embodiments. FIG. 5 is a cross-sectional view taken along a line D1-D1 of FIG. 1 according to one or more embodiments. FIG. 6 is a cross-sectional view taken along a line E1-E1 of FIG. 1 according to one or more embodiments.

Referring to FIGS. 1 to 6, the semiconductor device according to one or more embodiments may include a substrate 102, first and second active patterns AP1 and AP2, first and second gate structures GS1 and GS2, first and second epitaxial patterns SD1 and SD2, a first interlayer insulating layer 180, first and second frontside source/drain contacts FC1 and FC2, a second interlayer insulating layer 190, a frontside wiring structure FW, an insulating pattern 107, first to fourth backside source/drain contacts BC1 to BC4, first to third backside contact vias BV1 to BV3, and a backside wiring structure BW.

The substrate 102 may be made of bulk silicon or silicon-on-insulator (SOI). Alternatively, the substrate 102 may be a silicon substrate, or may include a material other than silicon, such as silicon germanium, silicon germanium on insulator (SGOI), indium antimonide, lead telluride compound, indium arsenide, indium phosphide, gallium arsenide, or gallium antimonide. Alternatively, the substrate 102 may include a base substrate and an epitaxial layer on the base substrate.

In one or more embodiments, the substrate 102 may be an insulating substrate including an insulating material. For example, the substrate 102 may include at least one of silicon oxide, silicon oxynitride, silicon oxycarbonitride, or a combination thereof. However, embodiments of the present disclosure are not limited thereto. For example, the substrate 102 may include a silicon oxide layer.

The substrate 102 may include a first surface 102a and a second surface 102b opposite to each other. The first surface 102a of the substrate 102 may also be referred to as a frontside surface or a frontside of the substrate 102, and the second surface 102b of the substrate 102 may also be referred to as a backside surface or a backside of the substrate 102.

The first and second active patterns AP1 and AP2 may be formed on the first surface 102a of the substrate 102. Each of the first and second active patterns AP1 and AP2 may extend in an elongate manner in a first direction X parallel to an upper surface of the substrate 102. The first and second active patterns AP1 and AP2 may be spaced apart from each other in a second direction Y parallel to the upper surface of the substrate 102 and intersecting the first direction X.

Each of the first and second active patterns AP1 and AP2 may include silicon (Si) or germanium (Ge) as an element semiconductor material. Alternatively, each of the first and second active patterns AP1 and AP2 may include a compound semiconductor, for example, a group IV-IV compound semiconductor or a group III-V compound semiconductor. The group IV-IV compound semiconductor may include, for example, a binary compound including two of carbon (C), silicon (Si), germanium (Ge), and tin (Sn), a ternary compound including three thereof, or a compound obtained by doping a group IV element thereto. The group III-V compound semiconductor may include, for example, a binary compound obtained by combining one of aluminum (Al), gallium (Ga), and indium (In) as a group III element and one of phosphorus (P), arsenic (As), and antimony (Sb) as a group V element with each other, a ternary compound obtained by combining two of aluminum (Al), gallium (Ga), and indium (In) as a group III element and one of phosphorus (P), arsenic (As), and antimony (Sb) as a group V with each other, or a quaternary compound obtained by combining three of aluminum (Al), gallium (Ga), and indium (In) as a group III element and one of phosphorus (P), arsenic (As), and antimony (Sb) as a group V with each other.

The first and second active patterns AP1 and AP2 may be provided as channel areas of the same conductivity type or channel areas of different conductivity types.

In one or more embodiments, each of the first and second active patterns AP1 and AP2 may include a plurality of bridge patterns 111 to 113. The plurality of bridge patterns 111 to 113 may be spaced apart from each other and sequentially stacked in a third direction Z intersecting the upper surface of the substrate 102 (e.g., the first surface 102a). The bridge patterns 111 to 113 may be used as a channel area of Multi-Bridge Channel Field Effect Transistor (MBCFET^{®}) including the multi-bridge channel. The number of the bridge patterns 111 to 113 included in each of the first and second active patterns AP1 and AP2 is only an example, and is not limited to the illustrated example.

The first gate structure GS1 may be formed on the first active pattern AP1. The first gate structure GS1 may extend in the second direction Y. The first gate structure GS1 may intersect the first active pattern AP1. For example, each of the bridge patterns 111 to 113 of the first active pattern AP1 may extend in the first direction X so as to penetrate the first gate structure GS1.

The second gate structure GS2 may be formed on the second active pattern AP2. The second gate structure GS2 may extend in the second direction Y. The second gate structure GS2 may intersect the second active pattern AP2. For example, each of the bridge patterns 111 to 113 of the second active pattern AP2 may extend in the first direction X so as to penetrate the second gate structure GS2.

The first and second gate structures GS1 and GS2 may be arranged in the second direction Y. In one or more embodiments, the first and second gate structures GS1 and GS2 may be spaced apart from each other in the second direction Y. For example, as illustrated in FIG. 4, a gate cutting pattern GC may be formed between the first gate structure GS1 and the second gate structure GS2. The gate cutting pattern GC may extend in the first direction X to physically and electrically isolate the first gate structure GS1 and the second gate structure GS2 from each other. The gate cutting pattern GC may include an insulating material, for example, at least one of silicon oxide, silicon nitride, silicon oxynitride, silicon oxycarbide, silicon boron nitride, silicon boron carbonitride, silicon oxycarbonitride, and combinations thereof. However, embodiments of the present disclosure are not limited thereto.

In one or more embodiments, the gate cutting pattern GC may not be formed between the first gate structure GS1 and the second gate structure GS2. In this case, the first and second gate structures GS1 and GS2 may be connected to each other in the second direction Y.

Each of the first and second gate structures GS1 and GS2 may include a gate dielectric layer 120, a gate electrode 130, a gate spacer 140, and a gate capping layer 150.

The gate dielectric layer 120 may be interposed between each of the first and second active patterns AP1 and AP2 and the gate electrode 130. For example, the gate dielectric layer 120 may conformally extend along an outer periphery of each of the bridge patterns 111 to 113. The gate dielectric layer 120 may include a dielectric material, for example, at least one of silicon oxide, silicon oxynitride, silicon nitride, or a high-k dielectric material having a dielectric constant greater than that of silicon oxide. The high-k material may include at least one of for example, hafnium oxide (HfO₂), zirconium oxide (ZrO₂), lanthanum oxide (La₂O₃), aluminum oxide (Al₂O₃), titanium oxide (TiO₂), strontium titanium oxide (SrTiO₃), lanthanum aluminum oxide (LaAlO₃), yttrium oxide (Y₂O₃), hafnium oxynitride (HfOₓN_{y}), zirconium oxynitride (ZrOₓN_{y}), lanthanum oxynitride (La₂OₓN_{y}), aluminum oxynitride (Al₂OₓN_{y}), titanium oxynitride (TiOₓN_{y}), strontium titanium oxynitride (SrTiOₓN_{y}), lanthanum aluminum oxynitride (LaAlOₓN_{y}), yttrium oxynitride (Y₂OₓN_{y}) or combinations thereof. However, embodiments of the present disclosure are not limited thereto.

The gate electrode 130 may be formed on the gate dielectric layer 120. The gate electrode 130 may extend in the second direction Y. Each of the bridge patterns 111 to 113 may extend in the first direction X so as to penetrate the gate electrode 130. The gate electrode 130 may include a conductive material, for example, at least one of TiN, WN, TaN, Ru, TiC, TaC, Ti, Ag, Al, TiAl, TiAlN, TiAlC, TaCN, TaSiN, Mn, Zr, W, Al, and a combination thereof. However, embodiments of the present disclosure are not limited thereto. The gate electrode 130 may be formed in a replacement process. However, embodiments of the present disclosure are not limited thereto.

Although the gate electrode 130 is shown as being embodied as a single layer, this is only an example, and the gate electrode may be embodied as a multi-layer structure formed by stacking a plurality of conductive layers. For example, the gate electrode 130 may include a work function adjustment layer for adjusting a work function, and a filling conductive layer for filling a space defined by the work function adjustment layer. The work function adjustment layer may include, for example, at least one of TiN, TaN, TiC, TaC, TiAlC, and a combination thereof. The filling conductive layer may include, for example, W or Al.

The gate spacer 140 may extend along a side surface of the gate electrode 130. Each of the bridge patterns 111 to 113 may extend in the first direction X so as to penetrate the gate spacer 140. The gate spacer 140 may include an insulating material, for example, at least one of silicon oxide, silicon nitride, silicon oxynitride, silicon oxycarbide, silicon boron nitride, silicon boron carbonitride, silicon oxycarbonitride, and combinations thereof. However, embodiments of the present disclosure are not limited thereto.

The gate capping layer 150 may extend along an upper surface of the gate electrode 130. The gate capping layer 150 may include an insulating material, for example, at least one of silicon oxide, silicon nitride, silicon oxynitride, silicon oxycarbide, silicon boron nitride, silicon boron carbonitride, silicon oxycarbonitride, and combinations thereof. However, embodiments of the present disclosure are not limited thereto.

In one or more embodiments, each of the first and second gate structures GS1 and GS2 may further include an inner spacer 145. The inner spacer 145 may be formed on a side surface of a portion of the gate electrode 130 between adjacent ones of the bridge patterns 111 to 113. The inner spacer 145 may be formed on a side surface of a portion of the gate electrode 130 between the substrate 102 and the bridge patterns 111 to 113. The inner spacer 145 may include an insulating material, for example, at least one of silicon oxide, silicon nitride, silicon oxynitride, silicon oxycarbide, silicon boron nitride, silicon boron carbonitride, silicon oxycarbonitride, and combinations thereof. However, embodiments of the present disclosure are not limited thereto.

In one or more embodiments, the first and second insulating structures IS1 and IS2 may be formed on the first and second active patterns AP1 and AP2. Each of the first and second insulating structures IS1 and IS2 may extend in the second direction Y. The first and second insulating structures IS1 and IS2 may be spaced apart from each other in the first direction X. Each of the first and second insulating structures IS1 and IS2 may include, for example, at least one of silicon oxide, silicon nitride, silicon oxynitride, silicon oxycarbide, silicon boron nitride, silicon boron carbonitride, silicon oxycarbonitride, and combinations thereof. However, embodiments of the present disclosure are not limited thereto. Each of the first and second insulating structures IS1 and IS2 may be provided to isolate elements adjacent to each other in the first direction X from each other. For example, one element area may be defined between the first insulating structure IS1 and the second insulating structure IS2.

The first and second gate structures GS1 and GS2 may be interposed between the first insulating structure IS1 and the second insulating structure IS2. For example, the first insulating structure IS1 may be disposed on one side of each of the first and second gate structures GS1 and GS2, and the second insulating structure IS2 may be disposed on the other side of each of the first and second gate structures GS1 and GS2.

The first epitaxial pattern SD1 may be formed on at least one side (e.g., both opposing sides) of the first gate structure GS1. The first epitaxial pattern SD1 may be formed on at least one side (e.g., both opposing sides) of the first insulating structure IS1 and/or at least one side (e.g., both opposing sides) of the second insulating structure IS2. The first epitaxial pattern SD1 may be connected to the first active pattern AP1. For example, each of the bridge patterns 111 to 113 of the first active pattern AP1 may connected to the first epitaxial pattern SD1 by penetrating the gate electrode 130 and the gate spacer 140. The first epitaxial pattern SD1 may be isolated from the gate electrode 130 via the gate dielectric layer 120, the gate spacer 140, and/or the inner spacer 145.

The second epitaxial pattern SD2 may be formed on at least one side of the second gate structure GS2. The second epitaxial pattern SD2 may be formed on at least one side of the first insulating structure IS1 and/or at least one side of the second insulating structure IS2. The second epitaxial pattern SD2 may be connected to the second active pattern AP2. For example, each of the bridge patterns 111 to 113 of the second active pattern AP2 may be connected to the second epitaxial pattern SD2 by penetrating the gate electrode 130 and the gate spacer 140. The second epitaxial pattern SD2 may be isolated from the gate electrode 130 via the gate dielectric layer 120, the gate spacer 140, and/or the inner spacer 145.

Each of the first and second epitaxial patterns SD1 and SD2 may include an epitaxial layer doped with impurities. For example, the first epitaxial pattern SD1 may include an epitaxial layer grown from the first active pattern AP1 using an epitaxial growth method. For example, the second epitaxial pattern SD2 may include an epitaxial layer grown from the second active pattern AP2 using an epitaxial growth method.

The first and second epitaxial patterns SD1 and SD2 may include impurities of the same conductivity type or impurities of different conductivity types.

For example, when the first active pattern AP1 and/or the second active pattern AP2 are provided as a channel area of the n-type FET (NFET), the first epitaxial pattern SD1 and/or the second epitaxial pattern SD2 may include N-type impurities (e.g., P, Sb, or As) or impurities for preventing diffusion of N-type impurities.

For example, when the first active pattern AP1 and/or the second active pattern AP2 are provided as the channel area of the p-type FET (PFET), the first epitaxial pattern SD1 and/or the second epitaxial pattern SD2 may include P-type impurities (e.g., B, In, Ga, or Al) or impurities for preventing diffusion of P-type impurities.

The first interlayer insulating layer 180 may be formed on the first surface 102a of the substrate 102. The first interlayer insulating layer 180 may be formed on the first and second gate structures GS1 and GS2 and the first and second epitaxial patterns SD1 and SD2. The first interlayer insulating layer 180 may fill a space on an outer side surface of each of the first and second gate structures GS1 and GS2. The first interlayer insulating layer 180 may cover the first and second epitaxial patterns SD1 and SD2.

The first interlayer insulating layer 180 may include, for example, at least one of silicon oxide, silicon nitride, silicon oxynitride, silicon oxycarbide, silicon boron nitride, silicon boron carbide, silicon oxycarbonitride, and a low dielectric constant (low-k) material having a dielectric constant lower than that of silicon oxide. However, embodiments of the present disclosure are not limited thereto. The low-k material may include, but is not limited to, at least one of FOX (Flowable Oxide), TOSZ (Tonene SilaZene), USG (Undoped Silica Glass), BSG (Borosilica Glass), PSG (PhosphoSilica Glass), BPSG (BoroPhosphoSilica Glass), PETEOS (Plasma Enhanced Tetra Ethyl Ortho Silicate), FSG (Fluoride Silicate Glass), CDO (Carbon Doped silicon Oxide), Xerogel, Aerogel, Amorphous Fluorinated Carbon, OSG (Organo Silicate Glass), Parylene, BCB (bis-benzocyclobutenes), SiLK, polyimide, porous polymeric material, and combinations thereof.

The first frontside source/drain contact FC1 may be disposed on one side of the second gate structure GS2. For example, the first frontside source/drain contact FC1 may be interposed between the second gate structure GS2 and the first insulating structure IS1. The first frontside source/drain contact FC1 may be formed on an upper surface of the second epitaxial pattern SD2. The first frontside source/drain contact FC1 may be connected to the second epitaxial pattern SD2. For example, the first frontside source/drain contact FC1 may contact the upper surface of the second epitaxial pattern SD2 by penetrating the first interlayer insulating layer 180.

The second frontside source/drain contact FC2 may be disposed on the other side of the first gate structure GS1 and the other side of the second gate structure GS2. For example, the second frontside source/drain contact FC2 may be interposed between the first gate structure GS1 and the second insulating structure IS2 and between the second gate structure GS2 and the second insulating structure IS2. The second frontside source/drain contact FC2 may be formed on the upper surface of the first epitaxial pattern SD1 and the upper surface of the second epitaxial pattern SD2. The second frontside source/drain contact FC2 may extend in the second direction Y so as to connect the first epitaxial pattern SD1 and the second epitaxial pattern SD2 to each other. For example, the second frontside source/drain contact FC2 may contact the upper surface of the first epitaxial pattern SD1 and the upper surface of the second epitaxial pattern SD2 by penetrating the first interlayer insulating layer 180.

Although each of the first and second frontside source/drain contacts FC1 and FC2 is illustrated as being embodied as a single layer, this is only an example. For example, each of the first and second frontside source/drain contacts FC1 and FC2 may include a barrier conductive layer and a filling conductive layer filling a space defined by the barrier conductive layer. The barrier conductive layer may include a metal or a metal nitride for preventing diffusion of a metal element included in the filling conductive layer, for example, at least one of titanium (Ti), tantalum (Ta), tungsten (W), nickel (Ni), cobalt (Co), platinum (Pt), an alloy thereof, and a nitride thereof. However, embodiments of the present disclosure are not limited thereto. The filling conductive layer may include, for example, at least one of aluminum (Al), copper (Cu), tungsten (W), molybdenum (Mo), cobalt (Co), ruthenium (Ru) and alloys thereof. However, embodiments of the present disclosure are not limited thereto.

In one or more embodiments, a first contact spacer 161 may be formed on a side surface of each of the first and second frontside source/drain contacts FC1 and FC2. The first contact spacer 161 may include an insulating material, for example, at least one of silicon oxide, silicon nitride, silicon oxynitride, silicon oxycarbide, silicon boron nitride, silicon boron carbonitride, silicon oxycarbonitride, and combinations thereof. However, embodiments of the present disclosure are not limited thereto.

In one or more embodiments, a first silicide layer 171 may be formed on a lower surfaces of each of the first and second frontside source/drain contacts FC1 and FC2. The first silicide layer 171 may be formed by reacting a metal element with a semiconductor element (e.g., silicon (Si)) included in the first epitaxial pattern SD1 and/or the second epitaxial pattern SD2. The first silicide layer 171 may include, for example, a metal silicide such as nickel silicide, cobalt silicide, tungsten silicide, titanium silicide, niobium silicide, or tantalum silicide. However, embodiments of the present disclosure are not limited thereto.

The second interlayer insulating layer 190 may be formed on the first interlayer insulating layer 180. The second interlayer insulating layer 190 may cover the first and second gate structures GS1 and GS2 and the first and second frontside source/drain contacts FC1 and FC2. The second interlayer insulating layer 190 may include, for example, at least one of silicon oxide, silicon nitride, silicon oxynitride, silicon oxycarbide, silicon boron nitride, silicon boron carbonitride, silicon oxycarbonitride, and the low dielectric constant material having a dielectric constant smaller than that of silicon oxide. However, embodiments of the present disclosure are not limited thereto.

The frontside wiring structure FW may be formed on the second interlayer insulating layer 190. The frontside wiring structure FW may include a frontside inter-wiring insulating layer 200 and frontside wiring patterns 211 and 212 in the frontside inter-wiring insulating layer 200. The shape, number, arrangement, and number of layers of the frontside wiring patterns 211 and 212 are only examples, and are not limited to those shown. Each of the frontside wiring patterns 211 and 212 may include a barrier conductive layer and a filling conductive layer.

In one or more embodiments, the frontside wiring patterns 211 and 212 may include a first frontside wiring pattern 211 and a second frontside wiring pattern 212 extending in an elongate manner in the first direction X, respectively. The first frontside wiring pattern 211 and the second frontside wiring pattern 212 may be spaced apart from each other in the second direction Y.

The first frontside wiring pattern 211 may be electrically connected to the first frontside source/drain contact FC1 and the second frontside source/drain contact FC2. For example, a first frontside contact via FV1 which penetrates the second interlayer insulating layer 190 to be connected to the first frontside source/drain contact FC1 may be formed. In addition, a second frontside contact via FV2 which penetrates the second interlayer insulating layer 190 to be connected to the second frontside source/drain contact FC2 may be formed. The first frontside wiring pattern 211 may be connected to the first frontside contact via FV1 and the second frontside contact via FV2. The first frontside source/drain contact FC1 and the second frontside source/drain contact FC2 may be electrically connected to each other via a first frontside wiring pattern 211 extending in the first direction X.

In one or more embodiments, each of the first frontside contact via FV1 and the second frontside contact via FV2 may be vertically above the second epitaxial pattern SD2 in the third direction Z.

The second frontside wiring pattern 212 may be electrically connected to the second frontside source/drain contact FC2. For example, a third frontside contact via FV3 which penetrates the second interlayer insulating layer 190 to be connected to the second frontside source/drain contact FC2 may be formed. The second frontside wiring pattern 212 may be connected to the third frontside contact via FV3. The first frontside wiring pattern 211 and the second frontside wiring pattern 212 may be electrically connected to each other via the second frontside source/drain contact FC2 extending in the second direction Y.

In one or more embodiments, the third frontside contact via FV3 may be vertically above the first epitaxial pattern SD1 in the third direction Z and may extend over the first epitaxial pattern SD1 in at least the X direction or the Y direction.

The insulating pattern 107 may be formed on a lower surface of the first gate structure GS1 and a lower surface of the second gate structure GS2. The insulating pattern 107 may be formed on the lower surface of the first insulating structure IS1 and/or the lower surface of the second insulating structure IS2. The first and second gate structures GS1 and GS2 may be vertically above and at least partially aligned with the insulating pattern 107 in the third direction Z, and the insulating pattern 107 may not be overlapped by the first and second epitaxial patterns SD1 and SD2 in the third direction Z (i.e., the first and second epitaxial patterns SD1 and SD2 may be horizontally offset from the insulating pattern 107). The insulating pattern 107 may extend in the second direction Y to cut (e.g. partition) the substrate 102. In other words, the insulating pattern 107 may extend in the second direction Y to partition the substrate 102. Specifically, the insulating pattern 107 may extend across the substrate 102 in the second direction Y and may extend through the substrate 102 in the third direction Z. The insulating pattern 107 may contact both the first surface 102a of the substrate 102 and the second surface 102b of the substrate 102. For example, an upper surface of the insulating pattern 107 may be connected to the first surface 102a of the substrate 102 and a lower surface of the insulating pattern 107 may be connected to the second surface 102b of the substrate 102. The insulating pattern 107 may include, for example, at least one of silicon oxide, silicon nitride, silicon oxynitride, silicon oxycarbide, silicon boron nitride, silicon boron carbonitride, silicon oxycarbonitride, and combinations thereof. However, embodiments of the present disclosure are not limited thereto.

In one or more embodiments, the upper surface of the insulating pattern 107 may be coplanar with the first surface 102a of the substrate 102. In one or more embodiments, the lower surface of the insulating pattern 107 may be coplanar with the second surface 102b of the substrate 102.

In one or more embodiments, a width of the insulating pattern 107 may decrease as the insulating pattern 107 extends from the second surface 102b of the substrate 102 toward the first surface 102a of the substrate 102. This may be due to performing of an etching process for forming the insulating pattern 107 in a direction from the second surface 102b of the substrate 102 toward the first surface 102a of the substrate 102.

The first backside source/drain contact BC1 may be disposed on one side of the first gate structure GS1. For example, the first backside source/drain contact BC1 may be interposed between the first gate structure GS1 and the first insulating structure IS1. The first backside source/drain contact BC1 may be formed on a lower surface of the first epitaxial pattern SD1. The first backside source/drain contact BC1 may be connected to the first epitaxial pattern SD1. For example, the first backside source/drain contact BC1 may contact the lower surface of the first epitaxial pattern SD1 by penetrating the substrate 102.

The second backside source/drain contact BC2 may be disposed on one side of the second gate structure GS2. For example, the second backside source/drain contact BC2 may be interposed between the second gate structure GS2 and the first insulating structure IS1. The second backside source/drain contact BC2 may be formed on the lower surface of the second epitaxial pattern SD2. The second backside source/drain contact BC2 may be connected to the second epitaxial pattern SD2. For example, the second backside source/drain contact BC2 may contact the lower surface of the second epitaxial pattern SD2 by penetrating the substrate 102.

The third backside source/drain contact BC3 may be disposed on the other side of the second gate structure GS2. For example, the third backside source/drain contact BC3 may be interposed between the second gate structure GS2 and the second insulating structure IS2. The third backside source/drain contact BC3 may be formed on the lower surface of the second epitaxial pattern SD2. The third backside source/drain contact BC3 may be connected to the second epitaxial pattern SD2. For example, the third backside source/drain contact BC3 may contact the lower surface of the second epitaxial pattern SD2 by penetrating the substrate 102.

The fourth backside source/drain contact BC4 may be disposed on the other side of the first gate structure GS1. For example, the fourth backside source/drain contact BC4 may be interposed between the first gate structure GS1 and the second insulating structure IS2. The fourth backside source/drain contact BC4 may be formed on the lower surface of the first epitaxial pattern SD1. The fourth backside source/drain contact BC4 may be connected to the first epitaxial pattern SD1. For example, the fourth backside source/drain contact BC4 may contact the lower surface of the first epitaxial pattern SD1 by penetrating the substrate 102.

Although each of the first to fourth backside source/drain contacts BC1 to BC4 is shown as being a single layer, this is only an example. For example, each of the first to fourth backside source/drain contacts BC1 to BC4 may include a barrier conductive layer and a filling conductive layer filling a space defined by the barrier conductive layer. The barrier conductive layer may include a metal or a metal nitride for preventing diffusion of a metal element included in the filling conductive layer, for example, at least one of titanium (Ti), tantalum (Ta), tungsten (W), nickel (Ni), cobalt (Co), platinum (Pt), an alloy thereof, and a nitride thereof. However, embodiments of the present disclosure are not limited thereto. The filling conductive layer may include, for example, at least one of aluminum (Al), copper (Cu), tungsten (W), molybdenum (Mo), cobalt (Co), ruthenium (Ru) and alloys thereof. However, embodiments of the present disclosure are not limited thereto.

In one or more embodiments, a second contact spacer 162 may be formed on a side surface of each of the first to fourth backside source/drain contacts BC1 to BC4. The second contact spacer 162 may include an insulating material, for example, at least one of silicon oxide, silicon nitride, silicon oxynitride, silicon oxycarbide, silicon boron nitride, silicon boron carbonitride, silicon oxycarbonitride, and combinations thereof. However, embodiments of the present disclosure are not limited thereto.

In one or more embodiments, a second silicide layer 172 may be formed on an upper surface of each of the first to fourth backside source/drain contacts BC1 to BC4. The second silicide layer 172 may be formed by reacting a metal element with a semiconductor element (e.g., silicon (Si)) included in the first epitaxial pattern SD1 and/or the second epitaxial pattern SD2. The second silicide layer 172 may include, for example, a metal silicide such as nickel silicide, cobalt silicide, tungsten silicide, titanium silicide, niobium silicide, or tantalum silicide. However, embodiments of the present disclosure are not limited thereto.

The first backside contact via BV1 may be disposed on one side of the insulating pattern 107 that is below each of the first and second gate structures GS1 and GS2. For example, the first backside contact via BV1 may be interposed between one insulating pattern 107 that is below each of the first and second gate structures GS1 and GS2 and another insulating pattern 107 that is below the first insulating structure IS1.

The first backside contact via BV1 may be connected to the first backside source/drain contact BC1 and the second backside source/drain contact BC2. The first backside contact via BV1 may extend in the second direction Y so as to connect the first backside source/drain contact BC1 and the second backside source/drain contact BC2 to each other. For example, the first backside source/drain contact BC1 may protrude from an upper surface of the first backside contact via BV1 so as to be connected to the first epitaxial pattern SD1, while the second backside source/drain contact BC2 may protrude from the upper surface of the first backside contact via BV1 so as to be connected to the second epitaxial pattern SD2.

In one or more embodiments, the first backside source/drain contact BC1, the second backside source/drain contact BC2, and the first backside contact via BV1 may be integrally formed with each other. For example, the first backside source/drain contact BC1, the second backside source/drain contact BC2, and the first backside contact via BV1 may have the same material composition.

The second backside contact via BV2 may be disposed on the other side of the insulating pattern 107 that is below the second gate structure GS2. For example, the second backside contact via BV2 may be interposed between one insulating pattern 107 that is below the second gate structure GS2 and another insulating pattern 107 that is below the second insulating structure IS2. The insulating pattern 107 that is below the second gate structure GS2 may isolate the first backside contact via BV1 and the second backside contact via BV2 from each other.

The second backside contact via BV2 may be connected to the third backside source/drain contact BC3. For example, the third backside source/drain contact BC3 may protrude from the upper surface of the second backside contact via BV2 so as to be connected to the second epitaxial pattern SD2.

In one or more embodiments, the third backside source/drain contact BC3 and the second backside contact via BV2 may be integrally formed with each other. For example, the third backside source/drain contact BC3 and the second backside contact via BV2 may have the same material component.

The third backside contact via BV3 may be disposed on the other side of the insulating pattern 107 that is below the first gate structure GS1. For example, the third backside contact via BV3 may be interposed between one insulating pattern 107 that is below the first gate structure GS1 and another insulating pattern 107 that is below the second insulating structure IS2. The insulating pattern 107 that is below the first gate structure GS1 may isolate the first backside contact via BV1 from the third backside contact via BV3.

The third backside contact via BV3 may be connected to the fourth backside source/drain contact BC4. For example, the fourth backside source/drain contact BC4 may protrude from the upper surface of the third backside contact via BV3 so as to be connected to the first epitaxial pattern SD1.

In one or more embodiments, the fourth backside source/drain contact BC4 and the third backside contact via BV3 may be integrally formed with each other. For example, the fourth backside source/drain contact BC4 and the third backside contact via BV3 may have the same material composition.

In one or more embodiments, a side surface of each of the first to third backside contact vias BV1 to BV3 may be defined by the insulating pattern 107. For example, the side surface of each of the first to third backside contact vias BV1 to BV3 may contact the side surface of the insulating pattern 107.

In one or more embodiments, the lower surface of each of the first to third backside contact vias BV1 to BV3 may be coplanar with the lower surface of the insulating pattern 107.

The backside wiring structure BW may be formed on the second surface 102b of the substrate 102. The backside wiring structure BW may include a backside inter-wiring insulating layer 300 and backside wiring patterns 311 to 314 in the backside inter-wiring insulating layer 300. The shape, number, arrangement, and number of layers of the backside wiring patterns 311 to 314 are only examples, and are not limited to those illustrated. Each of the backside wiring patterns 311 to 314 may include a barrier conductive layer and a filling conductive layer.

In one or more embodiments, the backside wiring patterns 311 to 314 may include a first backside wiring pattern 311, a second backside wiring pattern 312, a third backside wiring pattern 313, and a fourth backside wiring pattern 314, which extend in an elongate manner in the first direction X, respectively. The first backside wiring pattern 311 and the second backside wiring pattern 312 may be spaced apart from each other in the second direction Y. The second backside wiring pattern 312 and the third backside wiring pattern 313 may be spaced apart from each other in the first direction X. The first backside wiring pattern 311 and the fourth backside wiring pattern 314 may be spaced apart from each other in the first direction X.

The first backside wiring pattern 311 may be electrically connected to the first backside source/drain contact BC1 via the first backside contact via BV1. For example, the first backside wiring pattern 311 may contact a lower surface of the first backside contact via BV1 that is below the first backside source/drain contact BC1. In one or more embodiments, the first backside wiring pattern 311 may be below the first active pattern AP1 in the third direction Z.

The second backside wiring pattern 312 may be electrically connected to the second backside source/drain contact BC2 via the first backside contact via BV1. For example, the second backside wiring pattern 312 may contact a lower surface of the first backside contact via BV1 that is below the second backside source/drain contact BC2. In one or more embodiments, the second backside wiring pattern 312 may be below the second active pattern AP2 in the third direction Z.

The third backside wiring pattern 313 may be electrically connected to the third backside source/drain contact BC3 via the second backside contact via BV2. For example, the third backside wiring pattern 313 may contact a lower surface of the second backside contact via BV2 that is below the third backside source/drain contact BC3. In one or more embodiments, the third backside wiring pattern 313 may be below the second active pattern AP2 in the third direction Z.

The fourth backside wiring pattern 314 may be electrically connected to the fourth backside source/drain contact BC4 via the third backside contact via BV3. For example, the fourth backside wiring pattern 314 may contact the lower surface of the third backside contact via BV3 that is below the fourth backside source/drain contact BC4. In one or more embodiments, the fourth backside wiring pattern 314 may be below the first active pattern AP1 in the third direction Z.

The first backside wiring pattern 311 and the second backside wiring pattern 312 may be electrically connected to each other via the first backside contact via BV1 extending in the second direction Y. The second backside wiring pattern 312 and the third backside wiring pattern 313 may be electrically connected to each other via the first frontside wiring pattern 211 extending in the first direction X. The third backside wiring pattern 313 and the fourth backside wiring pattern 314 may be electrically connected to each other via the second frontside source/drain contact FC2 extending in the second direction Y.

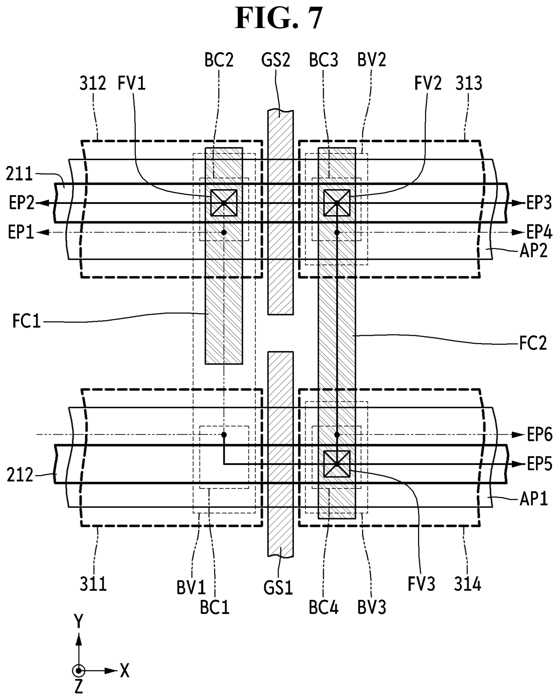

FIG. 7 is a diagram illustrating an electrical path of the semiconductor device of FIG. 1 according to one or more embodiments. Referring to FIG. 7, the semiconductor device according to one or more embodiments may provide a plurality of electrical paths EP1 to EP6. For example, the plurality of electrical paths EP1 to EP6 may include a first path EP1, a second path EP2, a third path EP3, a fourth path EP4, a fifth path EP5, and a sixth path EP6.

The first path EP1 may be composed of and pass through the first backside wiring pattern 311, the first backside contact via BV1, and the second backside wiring pattern 312.

The second path EP2 may be composed of and pass through the first backside wiring pattern 311, the first backside contact via BV1, the second backside source/drain contact BC2, the first frontside source/drain contact FC1, the first frontside contact via FV1, and the first frontside wiring pattern 211.

The third path EP3 may be composed of and pass through the first backside wiring pattern 311, the first backside contact via BV1, the second backside source/drain contact BC2, the second active pattern AP2, the second frontside source/drain contact FC2, the second frontside contact via FV2, and the first frontside wiring pattern 211. Alternatively, the third path EP3 may be composed of and pass through the first backside wiring pattern 311, the first backside contact via BV1, the first backside source/drain contact BC1, the first active pattern AP1, the second frontside source/drain contact FC2, the second frontside contact via FV2, and the first frontside wiring pattern 211.

The fourth path EP4 may be composed of and pass through the first backside wiring pattern 311, the first backside contact via BV1, the second backside source/drain contact BC2, the second active pattern AP2, the third backside source/drain contact BC3, the second backside contact via BV2, and the third backside wiring pattern 313. Alternatively, the fourth path EP4 may be composed of and pass through the first backside wiring pattern 311, the first backside contact via BV1, the first backside source/drain contact BC1, the first active pattern AP1, the second frontside source/drain contact FC2, the third backside source/drain contact BC3, the second backside contact via BV2, and the third backside wiring pattern 313.

The fifth path EP5 may be composed of and pass through the first backside wiring pattern 311, the first backside contact via BV1, the second backside source/drain contact BC2, the second active pattern AP2, the second frontside source/drain contact FC2, the third frontside contact via FV3, and the second frontside wiring pattern 212. Alternatively, the fifth path EP5 may be composed of and pass through the first backside wiring pattern 311, the first backside contact via BV1, the first backside source/drain contact BC1, the first active pattern AP1, the second frontside source/drain contact FC2, the third frontside contact via FV3, and the second frontside wiring pattern 212.

The sixth path EP6 may be composed of and pass through the first backside wiring pattern 311, the first backside contact via BV1, the second backside source/drain contact BC2, the second active pattern AP2, the second frontside source/drain contact FC2, the fourth backside source/drain contact BC4, the third backside contact via BV3, and the fourth backside wiring pattern 314. Alternatively, the sixth path EP6 may be composed of and pass through the first backside wiring pattern 311, the first backside contact via BV1, the first backside source/drain contact BC1, the first active pattern AP1, the fourth backside source/drain contact BC4, the third backside contact via BV3, and the fourth backside wiring pattern 314.

In one or more embodiments, the first backside wiring pattern 311 may be provided as a power wiring. For example, a power voltage (e.g., a source voltage VSS or a drain voltage VDD) may be applied to the first backside wiring pattern 311. The second backside wiring pattern 312 may transmit the power voltage via the first path EP1. The first frontside wiring pattern 211 may transmit the power voltage via the second path EP2 and/or the third path EP3. The third backside wiring pattern 313 may transmit the power voltage via the fourth path EP4. The second frontside wiring pattern 212 may transmit the power voltage via the fifth path EP 5. The fourth backside wiring pattern 314 may transmit the power voltage via the sixth path EP 6.

As the semiconductor device becomes more highly integrated, the widths of wiring patterns and via patterns implementing semiconductor devices are gradually decreasing. Accordingly, a voltage drop (e.g., a IR drop) of a Power Delivery Network (PDN) that supplies a power voltage to an integrated circuit has become an important issue.

The semiconductor device according to one or more embodiments may supply the power voltage using both the frontside wiring structure FW and the backside wiring structure BW. For example, as described above, the frontside wiring structure FW including the first and second frontside wiring patterns 211 and 212 may transmit the power voltage provided from the first backside wiring pattern 311 using the second path EP2, the third path EP3, and/or the fifth path EP5. In addition, as described above, the backside wiring structure BW including the second to fourth backside wiring patterns 312 to 314 may transmit the power voltage provided from the first backside wiring pattern 311 using the first path EP1, the fourth path EP4, and/or the sixth path EP 6. Accordingly, the semiconductor device according to one or more embodiments may provide a power distribution path diversified according to a design. In the semiconductor device according to one or more embodiments, the first backside contact via BV1 may extend in an elongate manner in the second direction Y to further diversify the power distribution path.

In addition, in the semiconductor device according to one or more embodiments, heat may be dissipated using both the frontside wiring structure FW and the backside wiring structure BW. Accordingly, the semiconductor device according to one or more embodiments may reduce a heat generation problem caused by transmitting the power voltage. Accordingly, the semiconductor device with improved design freedom and Power, Performance, Area, and Cost (PPAC) may be provided.

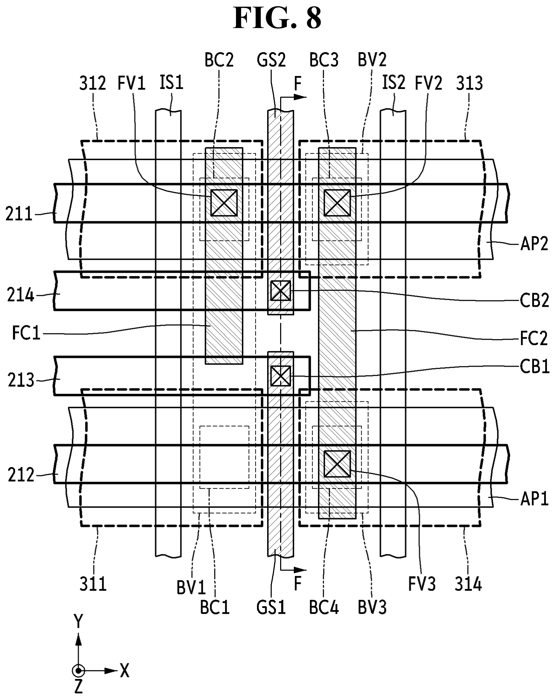

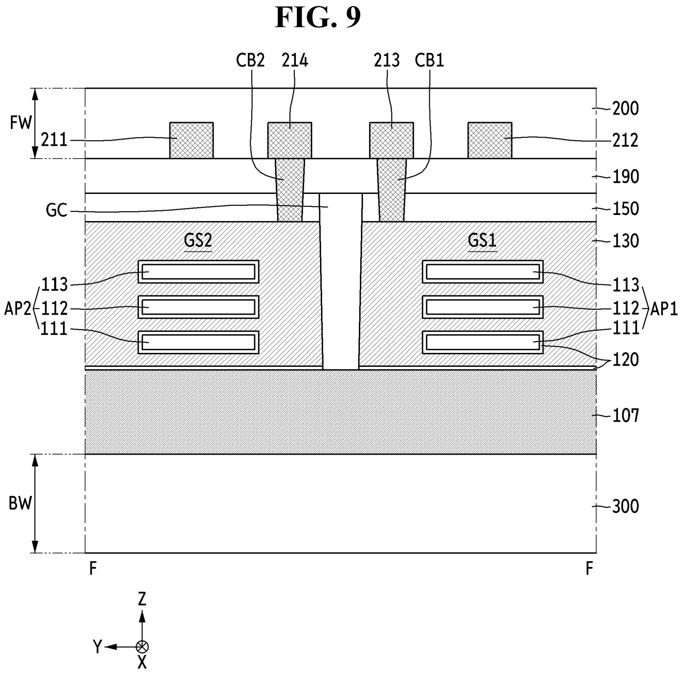

FIG. 8 is a diagram illustrating a semiconductor device according to one or more embodiments. FIG. 9 is a cross-sectional view taken along a line F-F of FIG. 8 according to one or more embodiments. Description of aspects that are the same as or similar to those described above may be omitted.

Referring to FIGS. 8 and 9, in the semiconductor device according to one or more embodiments, the frontside wiring structure FW includes a third frontside wiring pattern 213 and a fourth frontside wiring pattern 214.

The third frontside wiring pattern 213 may extend in the first direction X. The third frontside wiring pattern 213 may be electrically connected to the first gate structure GS1. For example, the first gate contact CB1 which penetrates the second interlayer insulating layer 190 and the gate capping layer 150 so as to be connected to the gate electrode 130 of the first gate structure GS1 may be formed. The third frontside wiring pattern 213 may be connected to the first gate contact CB1. Although the third frontside wiring pattern 213 is illustrated as being interposed between the first frontside wiring pattern 211 and the second frontside wiring pattern 212, embodiments are not limited thereto.

In one or more embodiments, a first gate voltage may be applied to the first gate structure GS1 via the third frontside wiring pattern 213. As the first gate voltage is applied, an electrical resistance of the electrical path (e.g., third to sixth paths EP3 to EP6 of FIG. 7) passing through the first active pattern AP1 may be reduced.

The fourth frontside wiring pattern 214 may extend in the first direction X. The fourth frontside wiring pattern 214 may be electrically connected to the second gate structure GS2. For example, the second gate contact CB2 which penetrates the second interlayer insulating layer 190 and the gate capping layer 150 so as to be connected to the gate electrode 130 of the second gate structure GS2 may be formed. The fourth frontside wiring pattern 214 may be connected to the second gate contact CB2. Although the fourth frontside wiring pattern 214 is illustrated only to be interposed between the first frontside wiring pattern 211 and the second frontside wiring pattern 212, embodiments are not limited thereto.

In one or more embodiments, a second gate voltage may be applied to the second gate structure GS2 via the fourth frontside wiring pattern 214. As the second gate voltage is applied, electrical resistance of the electrical paths (e.g., third to sixth paths EP3 to EP6 of FIG. 7) passing through the second active pattern AP2 may be reduced.

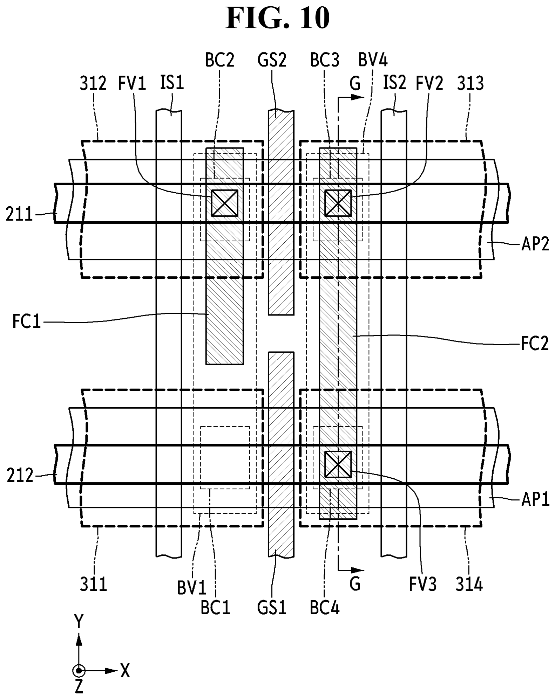

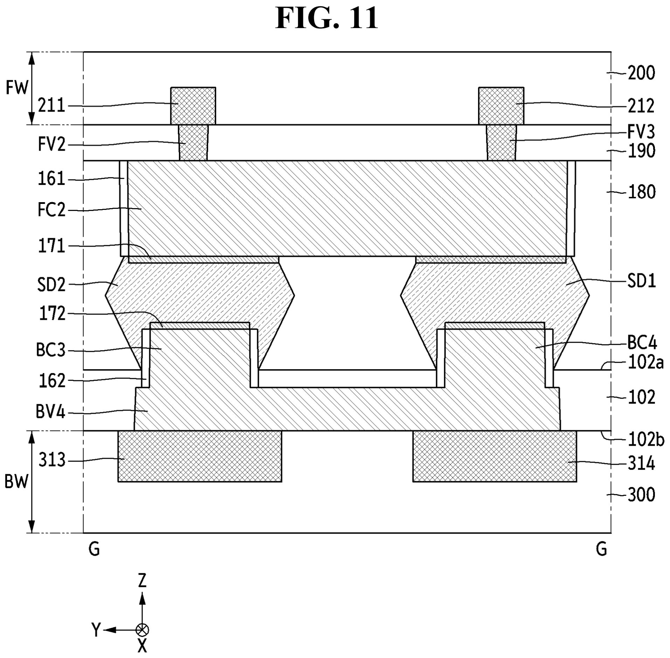

FIG. 10 is a diagram illustrating a semiconductor device according to one or more embodiments. FIG. 11 is a cross-sectional view taken along a line G-G of FIG. 10 according to one or more embodiments. Description of aspects that are the same as or similar to those described above may be omitted.

Referring to FIGS. 10 and 11, the semiconductor device according to one or more embodiments includes a fourth backside contact via BV4.

The fourth backside contact via BV4 may be disposed on the other side of the insulating pattern 107 that is below the first gate structure GS1 and the second gate structure GS2. For example, the fourth backside contact via BV4 may be interposed between one insulating pattern 107 that is below the first gate structure GS1 and the second gate structure GS2 and another insulating pattern 107 that is below the second insulating structure IS2.

The fourth backside contact via BV4 may be connected to the third backside source/drain contact BC3 and the fourth backside source/drain contact BC4. The fourth backside contact via BV4 may extend in the second direction Y so as to be connected to the third backside source/drain contact BC3 to the fourth backside source/drain contact BC4. For example, the third backside source/drain contact BC3 may protrude from an upper surface of the fourth backside contact via BV4 so as to be connected to the second epitaxial pattern SD2, and the fourth backside source/drain contact BC4 may protrude from the upper surface of the fourth backside contact via BV4 so as to be connected to the first epitaxial pattern SD1.

In one or more embodiments, the third backside source/drain contact BC3, the fourth backside source/drain contact BC4, and the fourth backside contact via BV4 may be integrally formed with each other. For example, the third backside source/drain contact BC3, the fourth backside source/drain contact BC4, and the fourth backside contact via BV4 may have the same material composition.

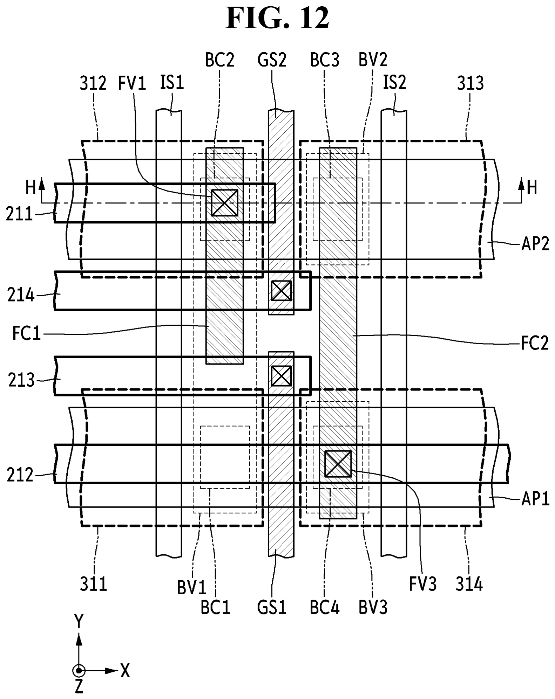

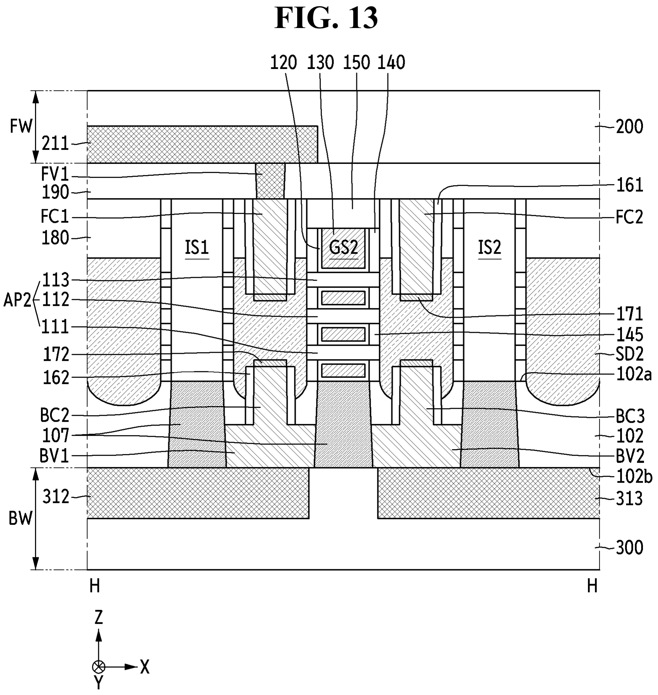

FIG. 12 is a diagram illustrating a semiconductor device according to one or more embodiments. FIG. 13 is a cross-sectional view taken along a line H-H of FIG. 12 according to one or more embodiments. Description of aspects that are the same as or similar to those described above may be omitted.

Referring to FIGS. 12 and 13, in the semiconductor device according to one or more embodiments, the second epitaxial pattern SD2 on one side of the second gate structure GS2 and the second epitaxial pattern SD2 on the other side of the second gate structure GS2 are configured to have different electrical potentials.

For example, the first frontside wiring pattern 211 may be connected to the first frontside source/drain contact FC1 and may not be connected to the second frontside source/drain contact FC2. In addition, the voltage applied to the first backside wiring pattern 311 and/or the second backside wiring pattern 312 may be different from the voltage applied to the third backside wiring pattern 313 and/or the fourth backside wiring pattern 314. Accordingly, the first frontside source/drain contact FC1 and the second frontside source/drain contact FC2 may be configured to have different electrical potentials. In addition, the second backside source/drain contact BC2 and the third backside source/drain contact BC3 may be configured to have different electrical potentials. Similarly, the first epitaxial pattern SD1 on one side of the first gate structure GS1 and the first epitaxial pattern SD1 on the other side of the first gate structure GS1 may be configured to have different electrical potentials.

In one or more embodiments, a first gate voltage may be applied to the first gate structure GS1 via the third frontside wiring pattern 213. On/off of the field effect transistor including the first active pattern AP1 and the first gate structure GS1 may be determined based on whether the first gate voltage is applied thereto.

In one or more embodiments, a second gate voltage may be applied to the second gate structure GS2 via the fourth frontside wiring pattern 214. On/off of the field effect transistor including the second active pattern AP2 and the second gate structure GS2 may be determined based on whether the second gate voltage is applied thereto.

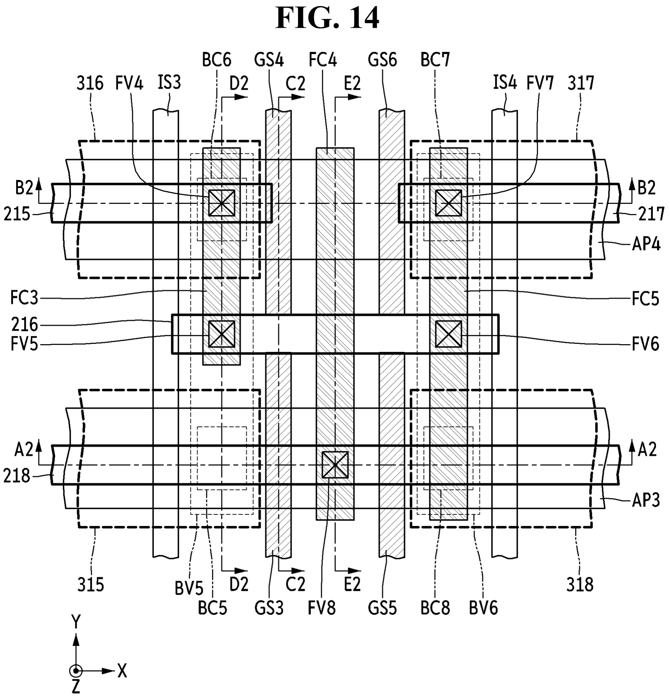

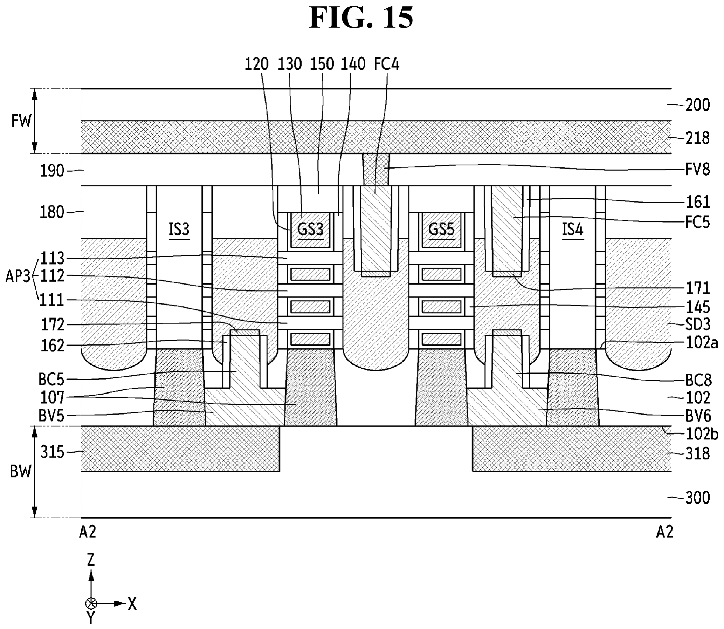

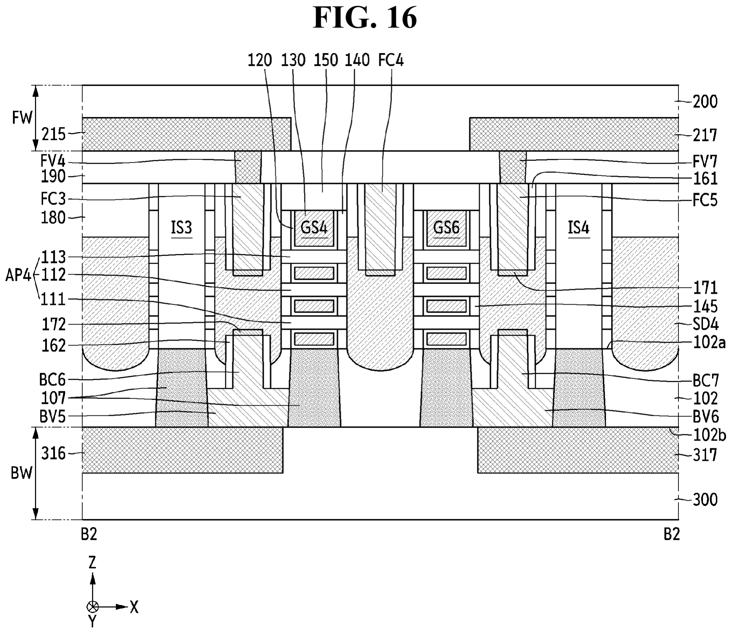

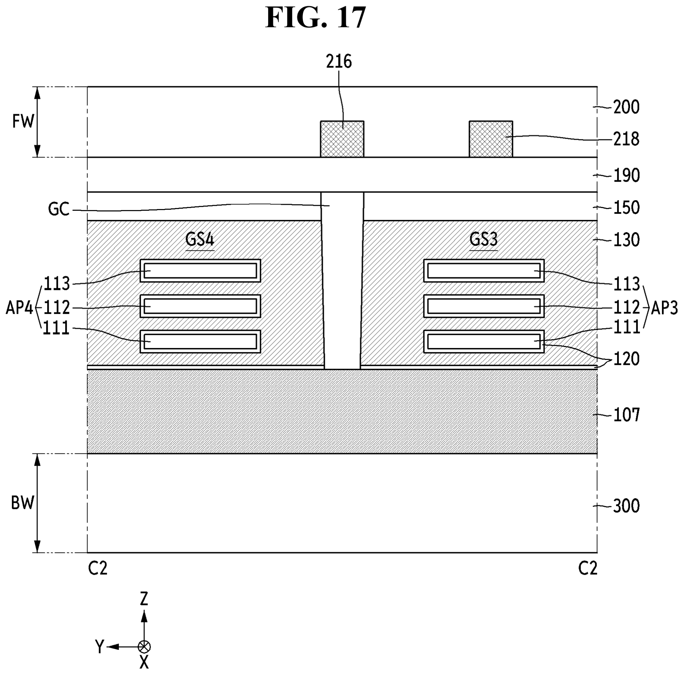

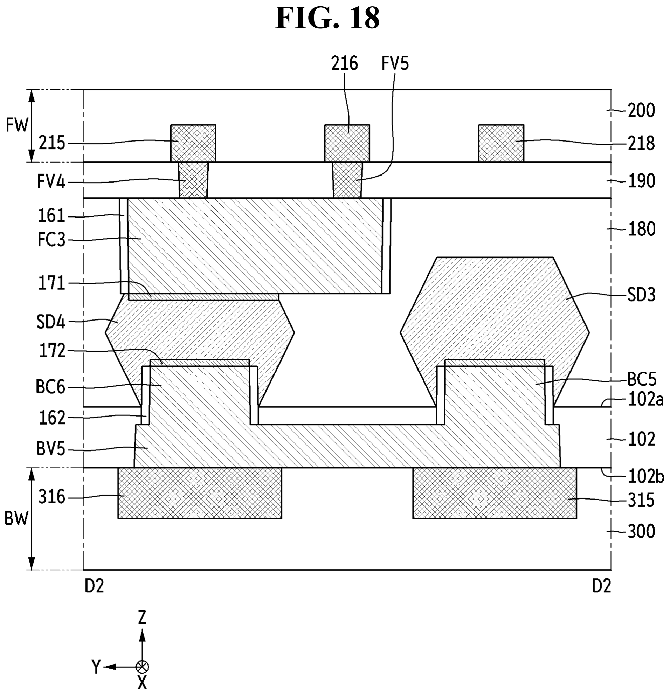

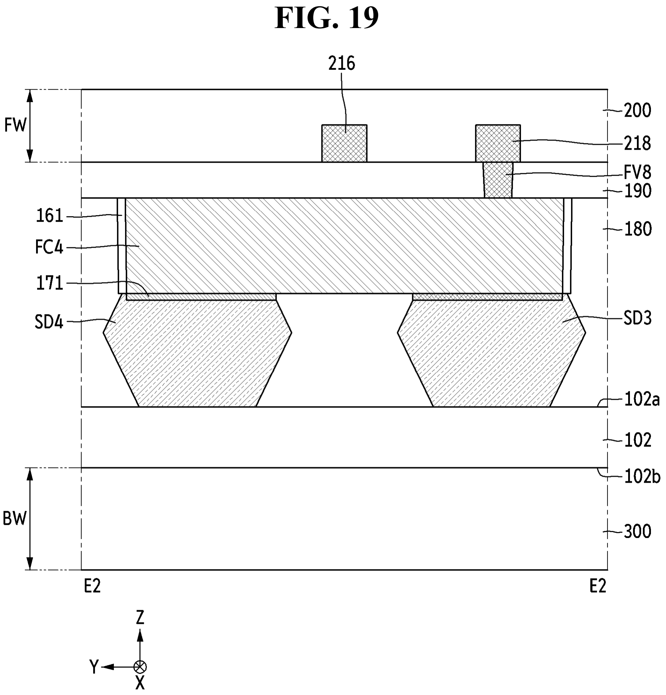

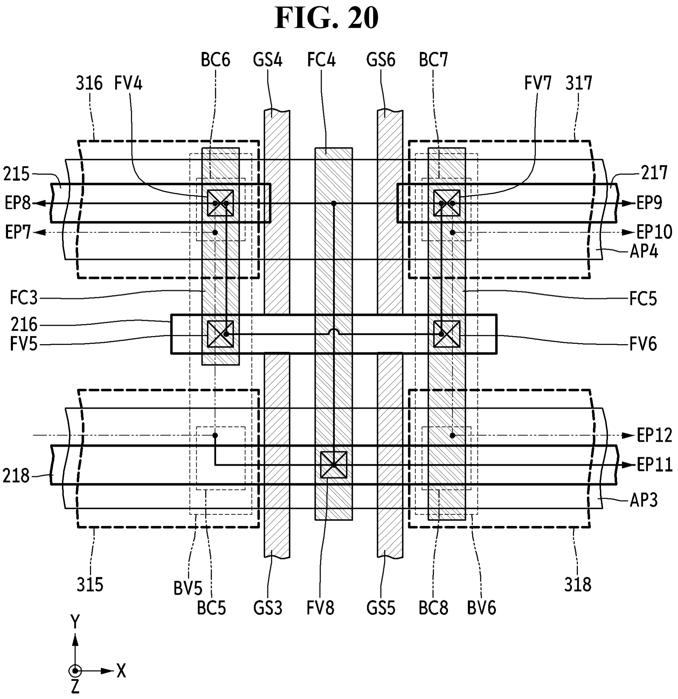

FIG. 14 is a diagram illustrating a semiconductor device according to one or more embodiments. FIG. 15 is a cross-sectional view taken along a line A2-A2 of FIG. 14 according to one or more embodiments. FIG. 16 is a cross-sectional view taken along a line B2-B2 of FIG. 14 according to one or more embodiments. FIG. 17 is a cross-sectional view taken along a line C2-C2 of FIG. 14 according to one or more embodiments. FIG. 18 is a cross-sectional view taken along a line D2-D2 of FIG. 14 according to one or more embodiments. FIG. 19 is a cross-sectional view taken along a line E2-E2 of FIG. 14 according to one or more embodiments. FIG. 20 is a diagram illustrating an electrical path of the semiconductor device of FIG. 14 according to one or more embodiments.

Referring to FIGS. 14 to 20, the semiconductor device according to one or more embodiments includes a substrate 102, third and fourth active patterns AP3 and AP4, third to sixth gate structures GS3 to GS6, third and fourth epitaxial patterns SD3 and SD4, a first interlayer insulating layer 180, third to fifth frontside source/drain contacts FC3 to FC5, a second interlayer insulating layer 190, a frontside wiring structure FW, an insulating pattern 107, fifth to eighth backside source/drain contacts BC5 to BC8, fifth and sixth backside contact vias BV5 and BV6, and a backside wiring structure BW.

The third and fourth active patterns AP3 and AP4 may be formed on the first surface 102a of the substrate 102. Each of the third and fourth active patterns AP3 and AP4 may extend in the first direction X. The third and fourth active patterns AP3 and AP4 may be spaced apart from each other in the second direction Y. The third and fourth active patterns AP3 and AP4 may be respectively similar to the first and second active patterns AP1 and AP2, and thus a detailed description thereof may be omitted below.

Each of the third to sixth gate structures GS3 to GS6 may extend in the second direction Y. Each of the third and fifth gate structures GS3 and GS5 may intersect the third active pattern AP3. The third and fifth gate structures GS3 and GS5 may be spaced apart from each other in the first direction X. Each of the fourth and sixth gate structures GS4 and GS6 may intersect the fourth active pattern AP4. The fourth and sixth gate structures GS4 and GS6 may be spaced apart from each other in the first direction X.

The third and fourth gate structures GS3 and GS4 may be arranged in the second direction Y. In one or more embodiments, the third and fourth gate structures GS3 and GS4 may be spaced apart from each other in the second direction Y. In one or more embodiments, the third and fourth gate structures GS3 and GS4 may be connected to each other in the second direction Y. The fifth and sixth gate structures GS5 and GS6 may be arranged in the second direction Y. In one or more embodiments, the fifth and sixth gate structures GS5 and GS6 may be spaced apart from each other in the second direction Y. In one or more embodiments, the fifth and sixth gate structures GS5 and GS6 may be connected to each other in the second direction Y.

Each of the third to sixth gate structures GS3 to GS6 may include the gate dielectric layer 120, the gate electrode 130, the gate spacer 140, and the gate capping layer 150. The third to sixth gate structures GS3 to GS6 may be respectively similar to the first and second gate structures GS1 and GS2, and thus a detailed description thereof may be omitted below.

In one or more embodiments, third and fourth insulating structures IS3 and IS4 may be formed on the third and fourth active patterns AP3 and AP4. Each of the third and fourth insulating structures IS3 and IS4 may extend in the second direction Y. The third and fourth insulating structures IS3 and IS4 may be spaced apart from each other in the first direction X. The third to sixth gate structures GS3 to GS6 may be interposed between the third insulating structure IS3 and the fourth insulating structure IS4. The third and fourth insulating structures IS3 and IS4 may be respectively similar to the first and second insulating structures IS1 and IS2, and thus a detailed description thereof may be omitted below.

The third epitaxial pattern SD3 may be formed on at least one side (e.g., both opposing sides) of the third gate structure GS3 and at least one side (e.g., both opposing sides) of the fifth gate structure GS5. The third epitaxial pattern SD3 may be formed on at least one side (e.g., both opposing sides) of the third insulating structure IS3 and/or at least one side (e.g., both opposing sides) of the fourth insulating structure IS4. The third epitaxial pattern SD3 may be connected to the third active pattern AP3.

The fourth epitaxial pattern SD4 may be formed on at least one side (e.g., both opposing sides) of the fourth gate structure GS4 and at least one side (e.g., both opposing sides) of the sixth gate structure GS6. The fourth epitaxial pattern SD4 may be formed on at least one side (e.g., both opposing sides) of the third insulating structure IS3 and/or at least one side (e.g., both opposing sides) of the fourth insulating structure IS4. The fourth epitaxial pattern SD4 may be connected to the fourth active pattern AP4.

Each of the third and fourth epitaxial patterns SD3 and SD4 may include an epitaxial layer doped with impurities. The third and fourth epitaxial patterns SD3 and SD4 may be respectively similar to the first and second epitaxial patterns SD1 and SD2, and thus a detailed description thereof may be omitted below.

The third frontside source/drain contact FC3 may be disposed on one side of the fourth gate structure GS4. For example, the third frontside source/drain contact FC3 may be interposed between the fourth gate structure GS4 and the third insulating structure IS3. The third frontside source/drain contact FC3 may be formed on an upper surface of the fourth epitaxial pattern SD4. The third frontside source/drain contact FC3 may be connected to the fourth epitaxial pattern SD4.

The fourth frontside source/drain contact FC4 may be interposed between the third gate structure GS3 and the fifth gate structure GS5 and between the fourth gate structure GS4 and the sixth gate structure GS6. The fourth frontside source/drain contact FC4 may be formed on an upper surface of the third epitaxial pattern SD3 and an upper surface of the fourth epitaxial pattern SD4. The fourth frontside source/drain contact FC4 may extend in the second direction Y so as to connect the third epitaxial pattern SD3 to the fourth epitaxial pattern SD4.

The fifth frontside source/drain contact FC5 may be disposed on the other side of the fifth gate structure GS5 and the other side of the sixth gate structure GS6. For example, the fifth frontside source/drain contact FC5 may be interposed between the fifth gate structure GS5 and the fourth insulating structure IS4 and between the sixth gate structure GS6 and the fourth insulating structure IS4. The fifth frontside source/drain contact FC5 may be formed on the upper surface of the third epitaxial pattern SD3 and the upper surface of the fourth epitaxial pattern SD4. The fifth frontside source/drain contact FC 5 may extend in the second direction Y so as to connect the third epitaxial pattern SD 3 and the fourth epitaxial pattern SD4.

The third to fifth frontside source/drain contacts FC3 to FC5 may be respectively similar to the first and second frontside source/drain contacts FC1 and FC2, and thus a detailed description thereof may be omitted below.

Each of the frontside wiring structures FW may include a fifth frontside wiring pattern 215, a sixth frontside wiring pattern 216, a seventh frontside wiring pattern 217, and an eighth frontside wiring pattern 218 that extend in an elongate manner in the first direction X.

The fifth frontside wiring pattern 215 may be electrically connected to the third frontside source/drain contact FC3. For example, the fourth frontside contact via FV4 which penetrates the second interlayer insulating layer 190 so as to be connected to the third frontside source/drain contact FC3 may be formed. The fifth frontside wiring pattern 215 may be connected to the fourth frontside contact via FV4.

The sixth frontside wiring pattern 216 may be electrically connected to the third frontside source/drain contact FC3 and the fifth frontside source/drain contact FC5. For example, a fifth frontside contact via FV5 which penetrates the second interlayer insulating layer 190 so as to be connected to the third frontside source/drain contact FC3 may be formed. In addition, a sixth frontside contact via FV6 which penetrates the second interlayer insulating layer 190 so as to be connected to the fifth frontside source/drain contact FC5 may be formed. The sixth frontside wiring pattern 216 may be connected to the fifth frontside contact via FV5 and the sixth frontside contact via FV6. The third frontside source/drain contact FC3 and the fifth frontside source/drain contact FC5 may be electrically connected to each other via the sixth frontside wiring pattern 216 extending in the first direction X.

The seventh frontside wiring pattern 217 may be electrically connected to the fifth frontside source/drain contact FC5. For example, a seventh frontside contact via FV7 may be formed to extend through the second interlayer insulating layer 190 so as to contact the fifth frontside source/drain contact FC5. The seventh frontside wiring pattern 217 may contact the seventh frontside contact via FV7.

The eighth frontside wiring pattern 218 may be electrically connected to the fourth frontside source/drain contact FC4. For example, an eighth frontside contact via FV8 which penetrates the second interlayer insulating layer 190 so as to be connected to the fourth frontside source/drain contact FC4 may be formed. The eighth frontside wiring pattern 218 may be connected to the eighth frontside contact via FV8.

The insulating pattern 107 may be formed on a lower surface of the third gate structure GS3, a lower surface of the fourth gate structure GS4, a lower surface of the fifth gate structure GS5, and a lower surface of the sixth gate structure GS6. The insulating pattern 107 may be formed on a lower surface of the third insulating structure IS3 and/or a lower surface of the fourth insulating structure IS4. The insulating pattern 107 may be below the third to sixth gate structures GS3 to GS6 in the third direction Z, and may not be below the third and fourth epitaxial patterns SD3 and SD4 (i.e., may not be vertically aligned with the third and fourth epitaxial patterns SD3 and SD4). The insulating pattern 107 may extend in the second direction Y to cut the substrate 102.

A fifth backside source/drain contact BC5 may be disposed on one side of the third gate structure GS3. For example, the fifth backside source/drain contact BC5 may be interposed between the third gate structure GS3 and the third insulating structure IS3. The fifth backside source/drain contact BC5 may be formed on the lower surface of the third epitaxial pattern SD 3. The fifth backside source/drain contact BC5 may be connected to the third epitaxial pattern SD 3.

A sixth backside source/drain contact BC6 may be disposed on one side of the fourth gate structure GS4. For example, the sixth backside source/drain contact BC6 may be interposed between the fourth gate structure GS4 and the third insulating structure IS3. The sixth backside source/drain contact BC6 may be formed on the lower surface of the fourth epitaxial pattern SD4. The sixth backside source/drain contact BC6 may be connected to the fourth epitaxial pattern SD4.

A seventh backside source/drain contact BC7 may be disposed on the other side of the sixth gate structure GS6. For example, the seventh backside source/drain contact BC7 may be interposed between the sixth gate structure GS6 and the fourth insulating structure IS4. The seventh backside source/drain contact BC7 may be formed on a lower surface of the fourth epitaxial pattern SD4. The seventh backside source/drain contact BC7 may be connected to the fourth epitaxial pattern SD4.

An eighth backside source/drain contact BC8 may be disposed on the other side of the fifth gate structure GS5. For example, the eighth backside source/drain contact BC8 may be interposed between the fifth gate structure GS5 and the fourth insulating structure IS4. The eighth backside source/drain contact BC8 may be formed on the lower surface of the third epitaxial pattern SD3. The eighth backside source/drain contact BC8 may be connected the third epitaxial pattern SD3.

The fifth to eighth backside source/drain contacts BC5 to BC8 may be respectively similar to the first to fourth backside source/drain contacts BC1 to BC4, and thus a detailed description thereof may be omitted below.

A fifth backside contact via BV5 may be disposed on one side of the insulating pattern 107 that is below the third and fourth gate structures GS3 and GS4. For example, the fifth backside contact via BV5 may be interposed between one insulating pattern 107 that is below the third and fourth gate structures GS3 and GS4 and another insulating pattern 107 that is below the third insulating structure IS3.

The fifth backside contact via BV5 may extend in the second direction Y so as to connect the fifth backside source/drain contact BC5 and the sixth backside source/drain contact BC6 to each other. For example, the fifth backside source/drain contact BC5 may protrude from the upper surface of the fifth backside contact via BV5 so as to be connected to the third epitaxial pattern SD3, and the sixth backside source/drain contact BC6 may protrude from the upper surface of the fifth backside contact via BV5 so as to be connected to the fourth epitaxial pattern SD4.

The sixth backside contact via BV6 may be disposed on the other side of the insulating pattern 107 that is below the fifth and sixth gate structures GS5 and GS6. For example, the sixth backside contact via BV6 may be interposed between one insulating pattern 107 that is below the fifth and sixth gate structures GS5 and GS6 and another insulating pattern 107 that is below the fourth insulating structure IS4.

The sixth backside contact via BV6 may extend in the second direction Y so as to connect the seventh backside source/drain contact BC7 and the eighth backside source/drain contact BC8 to each other. For example, the seventh backside source/drain contact BC7 may protrude from an upper surface of the sixth backside contact via BV6 so as to be connected to the fourth epitaxial pattern SD4, and the eighth backside source/drain contact BC8 may protrude from an upper surface of the sixth backside contact via BV6 so as to be connected to the third epitaxial pattern SD3.

The fifth and sixth backside contact vias BV5 and BV6 may be respectively similar to the first and fourth backside contact vias BV1 and BV4, and thus a detailed description thereof may be omitted below.

Each of the backside wiring structures BW may include a fifth backside wiring pattern 315, a sixth backside wiring pattern 316, a seventh backside wiring pattern 317, and an eighth backside wiring pattern 318 extending in an elongate manner in the first direction X. The fifth backside wiring pattern 315 and the sixth backside wiring pattern 316 may be spaced apart from each other in the second direction Y. The sixth backside wiring pattern 316 and the seventh backside wiring pattern 317 may be spaced apart from each other in the first direction X. The fifth backside wiring pattern 315 and the eighth backside wiring pattern 318 may be spaced apart from each other in the first direction X.

The fifth backside wiring pattern 315 may be electrically connected to the fifth backside source/drain contact BC5 via the fifth backside contact via BV5. In one or more embodiments, the fifth backside wiring pattern 315 may be below the third active pattern AP3 in the third direction Z.

The sixth backside wiring pattern 316 may be electrically connected to the sixth backside source/drain contact BC6 via the fifth backside contact via BV5. In one or more embodiments, the sixth backside wiring pattern 316 may be below the fourth active pattern AP4 in the third direction Z.

The seventh backside wiring pattern 317 may be electrically connected to the seventh backside source/drain contact BC7 via the sixth backside contact via BV6. In one or more embodiments, the seventh backside wiring pattern 317 may be below the fourth active pattern AP4 in the third direction Z.

The eighth backside wiring pattern 318 may be electrically connected to the eighth backside source/drain contact BC8 via the sixth backside contact via BV6. In one or more embodiments, the eighth backside wiring pattern 318 may be below the third active pattern AP3 in the third direction Z.

The fifth backside wiring pattern 315 and the sixth backside wiring pattern 316 may be electrically connected to each other via the fifth backside contact via BV5 extending in the second direction Y. The fifth backside wiring pattern 315, the seventh backside wiring pattern 317, and the eighth backside wiring pattern 318 may be electrically connected to each other via the sixth frontside wiring pattern 216 extending in the first direction X. The seventh backside wiring pattern 317 and the eighth backside wiring pattern 318 may be electrically connected to each other via the sixth backside contact via BV6 extending in the second direction Y.

Referring to FIG. 20, the semiconductor device according to one or more embodiments may provide a plurality of electrical paths EP7 to EP12. For example, the plurality of electrical paths EP7 to EP12 may include a seventh path EP7, an eighth path EP8, a ninth path EP9, a tenth path EP10, an eleventh path EP11, and a twelfth path EP12.

The seventh path EP7 may be composed of and pass through the fifth backside wiring pattern 315, the fifth backside contact via BV5, and the sixth backside wiring pattern 316.

The eighth path EP8 may be composed of and pass through the fifth backside wiring pattern 315, the fifth backside contact via BV5, the sixth backside source/drain contact BC6, the third frontside source/drain contact FC3, the fourth frontside contact via FV4, and the fifth frontside wiring pattern 215.

The ninth path EP9 may be composed of and pass through the fifth backside wiring pattern 315, the fifth backside contact via BV5, the sixth backside source/drain contact BC6, the third frontside source/drain contact FC3, the fifth frontside contact via FV5, the sixth frontside wiring pattern 216, the sixth frontside contact via FV6, the fifth frontside source/drain contact FC5, the seventh frontside contact via FV7, and the seventh frontside wiring pattern 217. Alternatively, the ninth path EP9 may be composed of and pass through the fifth backside wiring pattern 315, the fifth backside contact via BV5, the sixth backside source/drain contact BC6, the fourth active pattern AP4, the fifth frontside source/drain contact FC5, the seventh frontside contact via FV7, and the seventh frontside wiring pattern 217.

The tenth path EP10 may be composed of and pass through the fifth backside wiring pattern 315, the fifth backside contact via BV5, the sixth backside source/drain contact BC6, the third frontside source/drain contact FC3, the fifth frontside contact via FV5, the sixth frontside wiring pattern 216, the sixth frontside contact via FV6, the fifth frontside source/drain contact FC5, the seventh backside source/drain contact BC7, the sixth backside contact via BV6, and the seventh backside wiring pattern 317. Alternatively, the tenth path EP10 may be composed of and pass through the fifth backside wiring pattern 315, the fifth backside contact via BV5, the sixth backside source/drain contact BC6, the fourth active pattern AP4, the seventh backside source/drain contact BC7, the sixth backside contact via BV6, and the seventh backside wiring pattern 317.

The eleventh path EP11 may be composed of and pass through the fifth backside wiring pattern 315, the fifth backside contact via BV5, the fifth backside source/drain contact BC5, the third active pattern AP3, the fourth frontside source/drain contact FC4, the eighth frontside contact via FV8, and the eighth frontside wiring pattern 218. Alternatively, the eleventh path EP11 may be composed of and pass through the fifth backside wiring pattern 315, the fifth backside contact via BV5, the sixth backside source/drain contact BC6, the fourth active pattern AP4, the fourth frontside source/drain contact FC4, the eighth frontside contact via FV8, and the eighth frontside wiring pattern 218.

The twelfth path EP12 may be composed of and pass through the fifth backside wiring pattern 315, the fifth backside contact via BV5, the sixth backside source/drain contact BC6, the fourth active pattern AP4, the fifth frontside source/drain contact FC5, the eighth backside source/drain contact BC8, the sixth backside contact via BV6, and the eighth backside wiring pattern 318. Alternatively, the twelfth path EP12 may be composed of and pass through the fifth backside wiring pattern 315, the fifth backside contact via BV5, the sixth backside source/drain contact BC6, the fourth active pattern AP4, the seventh backside source/drain contact BC7, the sixth backside contact via BV6, and the eighth backside wiring pattern 318. Alternatively, the twelfth path EP12 may be composed of and pass through the fifth backside wiring pattern 315, the fifth backside contact via BV5, the sixth backside source/drain contact BC6, the third frontside source/drain contact FC3, the fifth frontside contact via FV5, the sixth frontside wiring pattern 216, the sixth frontside contact via FV6, the fifth frontside source/drain contact FC5, the eighth backside source/drain contact BC8, the sixth backside contact via BV6, and the eighth backside wiring pattern 318.

In one or more embodiments, the fifth backside wiring pattern 315 may be provided as a power wiring. For example, a power voltage (e.g., a source voltage VSS or a drain voltage VDD) may be applied to the fifth backside wiring pattern 315. The sixth backside wiring pattern 316 may transmit the power voltage via the seventh path EP7. The fifth frontside wiring pattern 215 may transmit the power voltage via the eighth path EP8. The seventh frontside wiring pattern 217 may transmit the power voltage via the ninth path EP9. The seventh backside wiring pattern 317 may transmit the power voltage via the tenth path EP10. The eighth frontside wiring pattern 218 may transmit the power voltage via the eleventh path EP11. The eighth backside wiring pattern 318 may transmit the power voltage via the twelfth path EP12.

Each of the embodiments provided in the above description is not excluded from being associated with one or more features of another example or another embodiment also provided herein or not provided herein but consistent with the disclosure.

While the disclosure has been particularly shown and described with reference to embodiments thereof, it will be understood that various changes in form and details may be made therein without departing from the scope of the following claims.

## Claims

1. A semiconductor device comprising:
a substrate (102) comprising a first surface (102a) and a second surface (102b) opposite to the first surface (102a);
a first active pattern (AP2) on the first surface (102a) of the substrate (102) and extending in a first direction (X);
a first gate structure (GS2) on the first active pattern (AP2) and extending in a second direction (Y) intersecting the first direction (X);
a first epitaxial pattern (SD2) on at least one side of the first gate structure (GS2) and connected to the first active pattern (AP2);
a first frontside source/drain contact (FC1; FC2) on an upper surface of the first epitaxial pattern (SD2) and connected to the first epitaxial pattern (SD2);
a frontside wiring structure (FW) on an upper surface of the first frontside source/drain contact (FC1; FC2) and connected to the first frontside source/drain contact (FC1; FC2);
an insulating pattern (107) on a lower surface of the first gate structure (GS2) and extending in the second direction (Y) to partition the substrate (102);
a first backside contact via (BV1) on at least one side of the insulating pattern (107);
a first backside source/drain contact (BC2) on a lower surface of the first epitaxial pattern (SD2) and connecting the first backside contact via (BV1) to the first epitaxial pattern (SD2); and
a backside wiring structure (BW) on the second surface (102b) of the substrate (102) and connected to the first backside contact via (BV1).

2. The semiconductor device of claim 1, further comprising:
a second active pattern (AP1) on the first surface (102a) and spaced apart from the first active pattern (AP2) in the second direction (Y), wherein the second active pattern (AP1) extends in the first direction (X);
a second gate structure (GS1) on the second active pattern (AP1) and extending in the second direction (Y);
a second epitaxial pattern (SD1) on at least one side of the second gate structure (GS1) and connected to the second active pattern (AP1); and
a second backside source/drain contact (BC1) on a lower surface of the second epitaxial pattern (SD1) and connected the second epitaxial pattern (SD1),
wherein the first backside contact via (BV1) extends in the second direction (Y) and connects the first backside source/drain contact (BC2) to the second backside source/drain contact (BC1).

3. The semiconductor device of claim 1 or 2, wherein the backside wiring structure (BW) comprises:
a first backside wiring pattern (311) connected to the first backside contact via (BV1); and
a second backside wiring pattern (312) spaced apart from the first backside wiring pattern (311) in the second direction (Y) and connected to the first backside contact via (BV1).

4. The semiconductor device of claim 1, wherein the first frontside source/drain contact (FC1) is at least partially aligned with the first backside source/drain contact (BC2) in a third direction (Z) intersecting the first direction (X) and the second direction (Y).

5. The semiconductor device of claim 1, wherein the first frontside source/drain contact (FC2) is on a first side of the first gate structure (GS2), and
wherein the first backside source/drain contact (BC2) is on a second side of the first gate structure (GS2).

6. The semiconductor device of any preceding claim, further comprising a gate contact (CB2) on an upper surface of the first gate structure (GS2) and connected to the first gate structure (GS2),
wherein the frontside wiring structure (FW) comprises a frontside wiring pattern (214) extending in the first direction (X) and connected to the gate contact (CB2).

7. The semiconductor device of claim 1, further comprising a second frontside source/drain contact (FC1) on the upper surface of the first epitaxial pattern (SD2) and connected to the first epitaxial pattern (SD2),
wherein the first frontside source/drain contact (FC2) is on a first side of the first gate structure (GS2), and
wherein the second frontside source/drain contact (FC1) is on a second side of the first gate structure (GS2).

8. The semiconductor device of claim 7, wherein the frontside wiring structure (FW) comprises a frontside wiring pattern (211) extending in the first direction (X) and connecting the first frontside source/drain contact (FC1) to the second frontside source/drain contact (FC2).

9. The semiconductor device of any preceding claim, further comprising:
a second backside contact via (BV2): and
a second backside source/drain contact (BC3) on the lower surface of the first epitaxial pattern (SD2) and connecting the second backside contact via (BV2) to the first epitaxial pattern (SD2); and
wherein the first backside contact via (BV1) is on a first side of the insulating pattern (107), and
wherein the second backside contact via (BV2) is on a second side of the insulating pattern (107).

10. The semiconductor device of claim 9, wherein the backside wiring structure (BW) comprises:
a first backside wiring pattern (312) connected to the first backside contact via (BV1); and
a second backside wiring pattern (313) spaced apart from the first backside wiring pattern (312) in the first direction (X) and connected to the second backside contact via (BV2).

11. The semiconductor device of any preceding claim, further comprising a frontside contact via (FV2) on the upper surface of the first frontside source/drain contact (FC2) and connected to the first frontside source/drain contact (FC2),
wherein the frontside wiring structure (FW) comprises a frontside wiring pattern (211) extending in the first direction (X) and connected to the frontside contact via (FV2).

12. The semiconductor device of any preceding claim, wherein the first active pattern (AP2) comprises a plurality of bridge patterns (111-113) spaced apart from each other in a third direction (Z) intersecting the first direction (X) and the second direction (Y), and
wherein each of the plurality of bridge patterns (111-113) extends in the first direction (X) and penetrates the first gate structure (GS2).

13. A semiconductor device comprising:
a substrate (102) comprising a first surface (102a) and a second surface (102b) opposite to the first surface (102a);
a first active pattern (AP1) on the first surface (102a) of the substrate (102) and extending in a first direction (X);
a second active pattern (AP2) on the first surface (102a) of the substrate (102) and spaced apart from the first active pattern (AP1) in a second direction (Y) intersecting the first direction (X), wherein the second active pattern (AP1) extends in the first direction (X) ;
a first gate structure (GS1) on the first active pattern (AP1) and extending in the second direction (Y);
a second gate structure (GS2) on the second active pattern (AP2) and extending in the second direction (Y);
a first epitaxial pattern (SD1) on at least one side of the first gate structure (GS1) and connected to the first active pattern (AP1);
a second epitaxial pattern (SD2) on at least one side of the second gate structure (GS2) and connected to the second active pattern (AP2);
a frontside source/drain contact (FC1) on an upper surface of the second epitaxial pattern (SD2) and connected to the second epitaxial pattern (SD2);
a frontside wiring structure (FW) on an upper surface of the frontside source/drain contact (FC1) and connected to the frontside source/drain contact (FC1);
a backside contact via (BV1) in the substrate (102) and extending in the second direction (Y);
a first backside source/drain contact (BC1) on a lower surface of the first epitaxial pattern (SD1) and connecting the backside contact via (BV1) to the first epitaxial pattern (SD1);
a second backside source/drain contact (BC2) on a lower surface of the second epitaxial pattern (SD2) and connecting the backside contact via (BV1) to the second epitaxial pattern (SD2);
a first backside wiring pattern (311) on the second surface (102b) of the substrate (102) and connected to the backside contact via (BV1); and
a second backside wiring pattern (312) on the second surface (102b) of the substrate (102) and spaced apart from the first backside wiring pattern (311) in the second direction (Y), wherein the second backside wiring pattern (312) is connected to the backside contact via (BV1).

14. The semiconductor device of claim 13, further comprising:
an insulating pattern (107) on a lower surface of the first gate structure (GS1) and a lower surface of the second gate structure (GS2), the insulating pattern (107) extending in the second direction (Y) to partition the substrate (102).

15. The semiconductor device of claim 13 or 14, wherein, in a third direction (Z) intersecting the first direction (X) and the second direction (Y), the first backside wiring pattern (311) is at least partially aligned with the first active pattern (AP1), and the second backside wiring pattern (312) is at least partially aligned with the second active pattern (AP2).
